# EUROPÄISCHE PATENTSCHRIFT

(11) **EP 3 756 889 B1**
(45) Veröffentlichungstag und Bekanntmachung des Hinweises auf die Patenterteilung: **17.04.2024**
(21) Anmeldenummer: 20191298.7
(22) Anmeldetag: 05.07.2017
(51) Int. Cl.: B33Y 30/00, B33Y 40/00

(54) **ANLAGE ZUR ADDITIVEN HERSTELLUNG DREIDIMENSIONALER OBJEKTE**
SYSTEM FOR ADDITIVE PRODUCTION OF THREE-DIMENSIONAL OBJECTS
INSTALLATION DE FABRICATION ADDITIVE D'OBJETS TRIDIMENSIONNELS

(30) Priorität: 19.12.2016 DE 102016124876
(43) Veröffentlichungstag der Anmeldung: 30.12.2020
(62) Teilanmeldung aus: 17179845.7
(73) Patentinhaber: Concept Laser GmbH, 96215 Lichtenfels (DE)
(72) Erfinder: HOFMANN, Alexander, 96260 Weismain (DE); STAMMBERGER, Jens, 96472 Rödental (DE); BRÜCKNER, Patrick, 96486 Lautertal (DE)
(74) Vertreter: Hafner & Kohl PartmbB

(56) Entgegenhaltungen:
- EP-A2- 1 769 902
- WO-A2-2007/025199
- DE-A1-102006 013 489
- US-A1- 2002 025 244
- US-B1- 9 120 622

## Beschreibung

Die Erfindung betrifft eine Anlage zur additiven Herstellung dreidimensionaler Objekte, umfassend wenigstens eine Arbeitsstation, welche zur Durchführung wenigstens eines Arbeitsvorgangs im Rahmen der additiven Herstellung dreidimensionaler Objekte eingerichtet ist.

Anlagen zur additiven Herstellung dreidimensionaler Objekte sind dem Grunde nach bekannt. Entsprechende Anlagen umfassen typischerweise eine oder mehrere Arbeitsstationen, welche jeweils zur Durchführung wenigstens eines Arbeitsvorgangs im Rahmen der additiven Herstellung dreidimensionaler Objekte eingerichtet sind.

Es ist bekannt, Pulvermodule, wie z. B. Baumodule, welche einen Bauraum begrenzen, in welchem der eigentliche additive Aufbau dreidimensionaler Objekte erfolgt, zwischen verschiedenen Arbeitsstationen einer Anlage zu befördern. Zur Beförderung entsprechender Pulvermodule wurden Transportwagen vorgeschlagen, welche über eine Aufnahmemöglichkeit zur Aufnahme eines zu befördernden Pulvermoduls verfügen.

Um in entsprechenden transportwagenseitigen Aufnahmemöglichkeiten aufgenommene Pulvermodule von einem entsprechenden Pulvermodul an bzw. in eine entsprechende Arbeitsstation, oder umgekehrt, zu übergeben, sind die Transportwagen an jeweilige arbeitsstationseitige Gehäusekonstruktionen anzudocken. Die Andockvorgänge jeweiliger Transportwagen an jeweilige arbeitsstationseitige Gehäusekonstruktionen sind bisweilen aufwändig.

Zudem ist die Handhabung der Transportwagen, insbesondere im mit einem Pulvermodul "beladenen" Zustand, bisweilen verbesserungswürdig, was auf einen vergleichsweise hohen Schwerpunkt der Transportwagen in deren mit einem Pulvermodul "beladenden" Zustand im Vergleich zu deren "unbeladenem" Zustand zurückzuführen ist.

DE 10 2006 023 489 A1 offenbart ein Gerät und Verfahren zum Ausrichten einer entnehmbaren Baukammer innerhalb einer Betriebskammer.

EP 1 769 902 A2 offenbart einen Stereolithografiedrucker und Stereolithografieverfahren. In dieser Druckschrift wird ein Transportwagen mit zugeführten Pulvermoduls offenbart, wobei die Struktur der Arbeitstation mit einer ersten Sicherungseinrichtung zur Sicherung eines Transportwagens ausgestattet ist und wobei der Transportwagen eine Hubeinrichtung umfasst.

US 9 120 622 B1 offenbart ein Prinzip zur Inventurkontrolle.

Der Erfindung liegt die Aufgabe zugrunde, eine verbesserte Anlage zur additiven Herstellung dreidimensionaler Objekte anzugeben, welche sich insbesondere durch verbesserte Transportwagen auszeichnet.

Die Aufgabe wird durch eine Anlage gemäß Anspruch 1 gelöst. Die hierzu abhängigen Aspekte betreffen mögliche Ausführungsformen der Anlage.

Die Erfindung ist in den Ansprüchen beschrieben.

Die hierin beschriebene Anlage ("Anlage") dient zur additiven Herstellung dreidimensionaler Objekte, d. h. beispielsweise technischer Bauteile bzw. technischer Bauteilgruppen. Die Anlage umfasst mehrere Arbeitsstationen, welche jeweils zur Durchführung wenigstens eines Arbeitsvorgangs im Rahmen der additiven Herstellung dreidimensionaler Objekte ("Objekte") eingerichtet sind. Entsprechende Arbeitsvorgänge im Rahmen der additiven Herstellung eines Objekts betreffen einerseits additive Arbeitsvorgänge, d. h. additive Bauvorgänge, in welchen tatsächlich ein additiver Aufbau eines Objekts, insbesondere durch sukzessive schichtweise selektive Belichtung und damit einhergehende sukzessive schichtweise selektive Verfestigung von Baumaterialschichten aus einem verfestigbaren Baumaterial vermittels eines Energiestrahls erfolgt, erfolgen, sowie vor jeweiligen additiven Arbeits- bzw. Bauvorgängen durchzuführende bzw. durchgeführte vorbereitende Arbeitsvorgänge, d. h. z. B. Reinigungs-, Inertisierungs- und Temperierungsvorgänge von Pulvermodulen, sowie nach jeweiligen additiven Arbeits- bzw. Bauvorgängen durchzuführende bzw. durchgeführte nachbereitende Arbeitsvorgänge, d. h. z. B. Auspackvorgänge additiv hergestellter Objekte aus entsprechenden Pulvermodulen.

Eine zur Durchführung additiver Arbeitsvorgänge eingerichtete, auch als Prozesstation zu bezeichnende erste Arbeitsstation kann als eine Vorrichtung ("Vorrichtung") zur additiven Herstellung von Objekten ausgebildet sein oder eine solche umfassen. Eine entsprechende Vorrichtung ist zur additiven Herstellung von Objekten, d. h. beispielsweise technischer Bauteile bzw. technischer Bauteilgruppen, durch sukzessive schichtweise selektive Belichtung und damit einhergehende sukzessive schichtweise selektive Verfestigung von Baumaterialschichten aus einem verfestigbaren Baumaterial eingerichtet. Bei dem Baumaterial kann es sich um ein partikuläres bzw. pulverförmiges Metall-, Kunststoff- und/oder Keramikmaterial handeln. Die selektive Verfestigung jeweiliger selektiv zu verfestigender Baumaterialschichten erfolgt auf Grundlage objektbezogener Baudaten. Entsprechende Baudaten beschreiben die geometrischkonstruktive Gestalt des jeweils additiv herzustellenden Objekts und können beispielsweise "geslicte" CAD-Daten des additiv herzustellenden Objekts beinhalten. Die Vorrichtung kann z. B. als SLM-Vorrichtung, d. h. als Vorrichtung zur Durchführung selektiver Laserschmelzverfahren (SLM-Verfahren), oder als SLS-Vorrichtung, d. h. als Vorrichtung zur Durchführung selektiver Lasersinterverfahren (SLS-Verfahren), ausgebildet sein.

Eine entsprechende Vorrichtung umfasst die zur Durchführung additiver Bauvorgänge typischerweise erforderlichen Funktionskomponenten. Hierzu zählen insbesondere eine Beschichtungseinrichtung, welche zur Ausbildung selektiv zu verfestigender Baumaterialschichten (in der Bauebene der Vorrichtung) eingerichtet ist, und eine Belichtungseinrichtung, welche zur selektiven Belichtung selektiv zu verfestigender Baumaterialschichten (in der Bauebene der Vorrichtung) eingerichtet ist. Die Beschichtungseinrichtung umfasst typischerweise mehrere Bestandteile, d. h. z. B. ein ein, insbesondere klingenförmiges, Beschichtungswerkzeug umfassendes Beschichtungselement sowie eine Führungseinrichtung zur Führung des Beschichtungselements entlang einer definierten Bewegungsbahn. Auch die Belichtungseinrichtung umfasst typischerweise mehrere Bestandteile, d. h. z. B. eine Strahlerzeugungseinrichtung zur Erzeugung eines Energie- bzw. Laserstrahls, eine Strahlablenkeinrichtung (Scannereinrichtung) zur Ablenkung eines von der Strahlerzeugungseinrichtung erzeugten Energie- bzw. Laserstrahls auf einen zu belichtenden Bereich einer selektiv zu verfestigenden Baumaterialschicht sowie diverse optische Elemente, wie z. B. Linsenelemente, Objektivelemente, etc. Die genannten Funktionskomponenten der Vorrichtung sind typischerweise an oder in einer, typischerweise inertisierbaren, Prozesskammer der Vorrichtung angeordnet oder ausgebildet.

Eine zur Durchführung nachbereitender Arbeitsvorgänge eingerichtete, auch als Nachbearbeitungsstation zu bezeichnende, optionale weitere (bzw. zweite) Arbeitsstation kann als eine Vorrichtung zum Auspacken eines additiv hergestellten Objekts ausgebildet sein oder eine solche umfassen. Die Vorrichtung kann zum Auspacken eines additiv hergestellten Objekts durch Entfernen des das additive hergestellte Objekte umgebenden, typischerweise nicht verfestigten, Baumaterials eingerichtet sein. Eine entsprechende Vorrichtung umfasst die zum Entfernen des das additive hergestellte Objekte umgebenden, typischerweise nicht verfestigten, Baumaterials erforderlichen Funktionskomponenten. Hierzu zählt insbesondere eine Saug- und/oder Gebläseeinrichtung, welche zur Erzeugung einer Saug- und/oder Gebläseströmung eingerichtet ist, vermittels welcher das zu entfernende Baumaterial abgesaugt oder abgeblasen werden kann.

Eine zur Durchführung vorbereitender Arbeitsvorgänge eingerichtete, auch als Vorbereitungsstation zu bezeichnende, optionale weitere (bzw. dritte) Arbeitsstation kann als eine Vorrichtung zum Reinigen und/oder Inertisieren und/oder Temperieren von Pulvermodulen ausgebildet sein oder eine solche umfassen. Die Vorrichtung kann zum Reinigen und/oder Inertisieren und/oder Temperieren von Pulvermodulen eingerichtet sein. Eine entsprechende Vorrichtung umfasst die zum Reinigen und/oder Inertisieren und/oder Temperieren von Pulvermodulen erforderlichen Funktionskomponenten. Hierzu zählt insbesondere eine Reinigungseinrichtung, welche z. B. zur Erzeugung einer eine pulvermodulseitig umfasste Pulverkammer reinigenden Reinigungsströmung eingerichtet ist, bzw. eine Inertisierungseinrichtung, welche zur Erzeugung einer eine pulvermodulseitig umfasste Pulverkammer inertisierende Inertgasströmung eingerichtet ist, bzw. eine Temperiereinrichtung, welche zur Temperierung eines Pulvermoduls auf eine bestimmte Zieltemperatur eingerichtet ist.

Unabhängig von ihrer konkreten funktionellen Ausführung umfassen jeweilige Arbeitsstationen typischerweise eine eigene Gehäusekonstruktion, an oder in welcher die Funktionskomponenten der jeweiligen Arbeitsstation angeordnet oder ausgebildet sind. Die Arbeitsstationen sind sonach als gesonderte, durch jeweilige Gehäusekonstruktionen räumlich-körperlich definierte Funktionseinheiten der Anlage zu sehen, welche in diversen Konfigurationen relativ zueinander, z. B. in einem oder mehreren Gebäude(abschnitte)n, insbesondere Fabrikhallen, positionierbar sind.

Die Anlage umfasst typischerweise eine Mehrzahl an im Rahmen der additiven Herstellung dreidimensionaler Objekte verwendeter Pulvermodule. Ein jeweiliges Pulvermodul ist zur Aufnahme und/oder Abgabe von Baumaterial eingerichtet und umfasst hierfür typischerweise eine Pulverkammer. Die Pulverkammer begrenzt einen mit Baumaterial befüllbaren Pulverraum. Der Pulverraum ist zumindest seitlich durch Wandungen (Pulverkammerwandungen) der in der Regel hohlquaderartig bzw. hohlzylinderartig ausgebildeten Pulverkammer begrenzt. Bodenseitig kann der Pulverraum durch eine Trägereinrichtung begrenzt sein. Eine entsprechende Trägereinrichtung ist typischerweise zwischen zwei Endstellungen, d. h. zwischen einer (bezogen auf die Höhe des Pulvermoduls) oberen und einer unteren Endstellung, relativ zu der Pulverkammer bewegbar gelagert. Die bewegbare Lagerung der Trägereinrichtung ermöglicht die Realisierung einer, insbesondere linearen, Bewegung der Trägereinrichtung entlang einer vertikalen Bewegungsachse bzw. in einer vertikalen Bewegungsrichtung. Die bewegbare Lagerung der Trägereinrichtung ist typischerweise durch eine mit dieser gekoppelte, insbesondere (elektro)motorische, Antriebs- und/oder Aktoreinrichtung realisiert.

Konkret kann es sich bei einem Pulvermodul um ein Baumodul, in welchem der eigentliche additive Aufbau von Objekten erfolgt und welches hierfür im Rahmen der Durchführung additiver Bauvorgänge sukzessive schichtweise mit selektiv zu verfestigendem Baumaterial befüllt wird, oder um ein Dosiermodul, über welches im Rahmen der Durchführung additiver Bauvorgänge Baumaterial in die Prozesskammer dosiert wird, oder um ein Auffang- bzw. Überlaufmodul, welches im Rahmen der Durchführung additiver Bauvorgänge mit nicht verfestigtem Baumaterial befüllt wird, handeln.

Die Anlage umfasst weiter wenigstens einen Transportwagen - wenngleich im Weiteren zumeist von einem Transportwagen die Rede ist, umfasst die Anlage typischerweise mehrere entsprechende Transportwagen. Der Transportwagen ist benutzerseitig, d. h. durch aktives Bewegen durch einen Benutzer, und/oder (teil)automatisiert über eine integrierte, insbesondere (elektro)motorische, Antriebseinrichtung zwischen verschiedenen Arbeitsstation der Anlage bewegbar bzw. verfahrbar. Sofern transportwagenseitig vorhanden, umfasst eine entsprechende Antriebseinrichtung typischerweise wenigstens eine Kraftübertragungseinrichtung, welche zur Übertragung einer von der Antriebseinrichtung erzeugten Antriebskraft auf einen Untergrund eingerichtet ist. Die Kraftübertragungseinrichtung kann z. B. eine Anzahl an Rädern, Rollen, Ketten, etc. umfassen, über welche eine Übertragung der von der Antriebseinrichtung erzeugten Antriebskraft auf einen Untergrund realisierbar ist.

Der Transportwagen umfasst eine Rahmenkonstruktion. Die Rahmenkonstruktion umfasst wenigstens zwei Rahmenkonstruktionsabschnitte. Ein erster Rahmenkonstruktionsabschnitt ist, insbesondere in einer vertikal ausgerichteten Bewegungsachse bzw. -richtung, relativ zu einem zweiten Rahmenkonstruktionsabschnitt bewegbar gelagert. Wenngleich grundsätzlich denkbar, ist der zweite Rahmenkonstruktionsabschnitt typischerweise nicht bewegbar gelagert. Der erste Rahmenkonstruktionsabschnitt ist typischerweise oberhalb des zweiten Rahmenkonstruktionsabschnitts angeordnet oder ausgebildet. Zur Realisierung von Bewegungen des ersten Rahmenkonstruktionsabschnitts relativ zu dem zweiten Rahmenkonstruktionsabschnitt umfasst der Transportwagen wenigstens eine, insbesondere (elektro)motorische, Hubeinrichtung. Die Hubeinrichtung ist zur Erzeugung einer den ersten Rahmenkonstruktionsabschnitt in eine Bewegung, d. h. eine Hebe- oder Senkbewegung, relativ zu dem zweiten Rahmenkonstruktionsabschnitt versetzenden Hubkraft eingerichtet.

Die Rahmenkonstruktion umfasst eine Aufnahmeeinrichtung Die Aufnahmeeinrichtung umfasst einen Aufnahmeraum bzw. ein Aufnahmevolumen. Der Aufnahmeraum ist zur Aufnahme wenigstens eines Pulvermoduls innerhalb der Rahmenkonstruktion eingerichtet. Die Abmessungen des Aufnahmeraums sind demnach so gewählt, dass der Aufnahmeraum zur (vollständigen) Aufnahme wenigstens eines Pulvermoduls eingerichtet ist. Die Aufnahmeeinrichtung, d. h. insbesondere der Aufnahmeraum, ist typischerweise in dem ersten Rahmenkonstruktionsabschnitt angeordnet oder ausgebildet.

Die Hubeinrichtung ist eingerichtet, den ersten Rahmenkonstruktionsabschnitt wenigstens zwischen einer Transportposition, in welcher eine Übergabe eines Pulvermoduls von dem Transportwagen in eine Arbeitsstation, oder umgekehrt, nicht möglich ist, und einer Übergabeposition, in welcher eine Übergabe eines Pulvermoduls von dem Transportwagen in eine Arbeitsstation möglich ist, zu bewegen. Bei der Transport- bzw. der Übergabeposition handelt es sich typischerweise um bestimmte vertikale Positionen des ersten Rahmenkonstruktionsabschnitts relativ zu dem zweiten Rahmenkonstruktionsabschnitt. Die Übergabeposition stellt typischerweise eine, insbesondere im Vergleich zu der Transportposition, obere Position des ersten Rahmenkonstruktionsabschnitts dar. Die Transportposition stellt typischerweise eine, insbesondere im Vergleich zu der Übergabeposition, untere Position des ersten Rahmenkonstruktionsabschnitts dar. Die bewegbare Lagerung des ersten Rahmenkonstruktionsabschnitts relativ zu dem zweiten Rahmenkonstruktionsabschnitt ermöglicht die Realisierung unterschiedlicher (vertikaler) Positionen des ersten Rahmenkonstruktionsabschnitts, welche typischerweise mit einer Verlagerung des Schwerpunkts des Transportwagens einhergehen, welche sich positiv auf die Bewegungs- bzw. Fahreigenschaften des Transportwagens auswirken. Durch den in der Transportposition vergleichsweise tiefen Schwerpunkt des Transportwagens ist die mögliche Gefahr eines Verkippens des Transportwagens ausgeschlossen bzw. reduziert. Der Transportwagen ist in eine Vorandockposition bewegbar. In der Vorandockposition ist der Transportwagen mit einem bestimmten Abstand, d. h. insbesondere einem Abstand in einem Bereich zwischen 5 und 15 cm, beabstandet von einer arbeitsstationseitigen Gehäusekonstruktion angeordnet. Die Vorandockposition kann als Vorstufe für eine spätere Andockposition, in welcher der Transportwagen tatsächlich an eine arbeitsstationseitige Gehäusekonstruktion andockt, erachtet werden; in der Vorandockposition ist eine Übergabe eines Pulvermoduls von einem Transportwagen in eine Arbeitsstation, oder umgekehrt, typischerweise nicht möglich bzw. nicht vorgesehen.

Die Anlage umfasst eine erste Sicherungseinrichtung. Die erste Sicherungseinrichtung ist zur Sicherung eines in die Vorandockposition bewegten Transportwagens in der Vorandockposition eingerichtet. Die erste Sicherungseinrichtung ist sonach zur Sicherung der Position eines in die Vorandockposition bewegten Transportwagens relativ zu der arbeitsstationseitigen Gehäusekonstruktion eingerichtet.

Die erste Sicherungseinrichtung kann wenigstens ein arbeitsstationseitiges erstes Sicherungselement und wenigstens ein korrespondierendes transportwagenseitiges Gegensicherungselement umfassen. Das arbeitsstationseitige, d. h. an der Arbeitsstation angeordnete oder ausgebildete, erste Sicherungselement ist eingerichtet, mit einem transportwagenseitigen, d. h. an dem Transportwagen angeordneten oder ausgebildeten, Gegensicherungselement derart zusammenzuwirken, dass die Position des in die Vorandockposition bewegten Transportwagens relativ zu der arbeitsstationseitigen Gehäusekonstruktion gesichert ist, mithin der Transportwagen nicht aus der Vorandockposition bewegt werden kann. Das arbeitsstationseitige Sicherungselement und das transportwagenseitige Gegensicherungselement können in der Sicherungsstellung formschlüssig zusammenwirken. Das arbeitsstationseitige Sicherungselement kann demnach als Formschlusselement, d. h. z. B. als, insbesondere hakenartiger bzw. -förmiger, Vorsprung, ausgebildet sein oder einen solchen umfassen. Das transportwagenseitige Gegensicherungselement kann als korrespondierendes Gegenformschlusselement, d. h. z. B. als, insbesondere nutartige bzw. -förmige, Aufnahme für den Vorsprung, ausgebildet sein oder eine solche umfassen.

Das arbeitsstationseitige Sicherungselement kann zwischen einer Sicherungsstellung, in welcher es derart relativ zu einem transportwagenseitigen Gegensicherungselement bewegt ist, dass es mit diesem unter Ausbildung einer Sicherung der Vorandockposition des Transportwagens zusammenwirkt, und einer Nichtsicherungsstellung, in welcher es derart relativ zu einem transportwagenseitigen Gegensicherungselement bewegt ist, dass es nicht mit diesem unter Ausbildung einer Sicherung der Andockposition des Transportwagens zusammenwirkt, bewegbar gelagert sein. Die bewegbare Lagerung des Sicherungselements kann durch eine Stelleinrichtung realisiert sein. Die Stelleinrichtung kann wenigstens ein mit dem Sicherungselement (bewegungs)gekoppeltes Stellelement umfassen. Die Stelleinrichtung kann z. B. als eine einen bewegbar gelagerten Stellkolben umfassende Kolben-Zylinder-Einrichtung ausgebildet sein oder eine solche umfassen.

Alternativ oder ergänzend kann (auch) ein transportwagenseitiges Gegensicherungselement zwischen einer Sicherungsstellung, in welcher es derart relativ zu einem arbeitsstationseitigen Sicherungselement bewegt ist, dass es mit diesem unter Ausbildung einer Sicherung der Vorandockposition des Transportwagens zusammenwirkt, und einer Nichtsicherungsstellung, in welcher es derart relativ zu einem arbeitsstationseitigen Sicherungselement bewegt ist, dass es nicht mit diesem unter Ausbildung einer Sicherung der Andockposition des Transportwagens zusammenwirkt, bewegbar gelagert sein. Auch die bewegbare Lagerung des Gegensicherungselements kann durch eine Stelleinrichtung realisiert sein. Die Stelleinrichtung kann wenigstens ein mit dem Gegensicherungselement (bewegungs)gekoppeltes Stellelement umfassen. Die Stelleinrichtung kann z. B. als Schwenkeinrichtung, welche zur Verschwenkung des Gegensicherungselements zwischen der Sicherungs- und der Nichtsicherungsstellung eingerichtet ist, ausgebildet sein oder eine solche umfassen.

Die Anlage umfasst eine erste Erfassungseinrichtung. Die erste Erfassungseinrichtung ist zur Erfassung eines in die Vorandockposition bewegten Transportwagens und zur Erzeugung einer einen in die Vorandockposition bewegten Transportwagen beschreibenden Vorandockpositionsinformation eingerichtet. Ergänzend ist die erste Erfassungseinrichtung zur Erfassung einer vermittels der ersten Sicherungseinrichtung realisierten Sicherung eines in die Vorandockposition bewegten Transportwagens und zur Erzeugung einer eine vermittels der ersten Sicherungseinrichtung realisierte Sicherung eines in die Vorandockposition bewegten Transportwagens beschreibenden ersten Sicherungsinformation eingerichtet. Die erste Erfassungseinrichtung kann wenigstens ein, z. B. akustisches, elektrisches, optisches oder haptisches, Erfassungselement umfassen, welches auf Grundlage, z. B. akustischer, elektrischer, optischer oder haptischer, Signale Rückschlüsse auf die Positionierung und/oder Sicherung eines Transportwagens in der Vorandockposition ziehen kann. Konkrete Beispiele für ein Erfassungselement sind eine (akustische oder optische) Schranke oder ein (elektrischer und/oder mechanischer) Kontakt. Jeweilige Erfassungselemente können arbeitsstationseitig und/oder transportwagenseitig angeordnet oder ausgebildet sein. Unabhängig von ihrer konkreten Ausführungsform lässt sich über die erste Erfassungseinrichtung erfassen, ob ein Transportwagen in die Vorandockposition bewegt ist und/oder ob ein in die Vorandockposition bewegter Transportwagen in der Vorandockposition gesichert ist. Das jeweilige Erfassungsergebnis wird über die Vorandockpositionsinformation bzw. über die Sicherungsinformation abgebildet.

Die transportwagenseitige Hubeinrichtung ist eingerichtet, eine den ersten Rahmenkonstruktionsabschnitt, insbesondere ausgehend von der Transportposition, in eine Bewegung relativ zu dem zweiten Rahmenkonstruktionsabschnitt versetzende Hubkraft auf Grundlage einer Vorandockpositionsinformation und/oder auf Grundlage einer Sicherungsinformation zu erzeugen. Insbesondere ist die Hubeinrichtung, insbesondere ausgehend von der Transportposition, eingerichtet, den ersten Rahmenkonstruktionsabschnitt dann, wenn ein Transportwagen in die Vorandockposition bewegt ist und/oder wenn ein in die Vorandockposition bewegter Transportwagen in der Vorandockposition gesichert ist, in eine Bewegung in Richtung einer weiter unten beschriebenen Vorübergabeposition bzw. in Richtung der Übergabeposition zu versetzen. Derart kann insbesondere die Sicherheit der Anlage verbessert werden.

Der Transportwagen kann eine der transportwagenseitigen Hubeinrichtung zugeordnete Hubfreigabeeinrichtung umfassen. Die Hubfreigabeeinrichtung ist eingerichtet, auf Grundlage eines über eine, insbesondere transportwagenseitige, Benutzerschnittstelle benutzerseitig, z. B. durch eine haptische Eingabe, erzeugten Freigabebefehls eine Freigabeinformation zu erzeugen. Die Hubfreigabeeinrichtung kann entsprechend eine benutzerseitig betätigbare bzw. betätigende Betätigungsschnittstelle, d. h. z. B. einen Taster, Knopf, Touchscreen, etc. umfassen. Die Hubeinrichtung kann eingerichtet sein, die den ersten Rahmenkonstruktionsabschnitt relativ zu dem zweiten Rahmenkonstruktionsabschnitt versetzende Hubkraft auf Grundlage einer seitens der Hubfreigabeeinrichtung erzeugten Freigabeinformation zu erzeugen. Mithin kann, bevor eine tatsächliche Bewegung des ersten Rahmenkonstruktionsabschnitts erfolgt, eine Benutzerfreigabe erforderlich sein. Derart kann die Sicherheit der Anlage weiter verbessert werden.

Es wurde erwähnt, dass die transportwagenseitige Hubeinrichtung insbesondere eingerichtet ist, den ersten Rahmenkonstruktionsabschnitt zwischen einer Transportposition und einer Übergabeposition zu bewegen. Die Hubeinrichtung kann ferner eingerichtet sein, den ersten Rahmenkonstruktionsabschnitt, insbesondere ausgehend von der Transportposition des ersten Rahmenkonstruktionsabschnitts und der Vorandockposition des Transportwagens, in eine oberhalb der Übergabeposition liegende Vorübergabeposition zu bewegen. Die Vorübergabeposition kann (in vertikaler Richtung) einige cm, d. h. z. B. zwischen 5 und 15 cm, oberhalb der Übergabeposition liegen. Die Vorübergabeposition kann als Vorstufe für eine Übergabeposition, in welcher, wie erwähnt, eine Übergabe eines Pulvermoduls von dem Transportwagen in die Arbeitsstation, oder umgekehrt, möglich ist, erachtet werden; in der Vorübergabeposition ist eine Übergabe eines Pulvermoduls von einem Transportwagen in eine Arbeitsstation, oder umgekehrt, typischerweise noch nicht möglich bzw. nicht vorgesehen.

Die Anlage umfasst eine zweite Erfassungseinrichtung. Die zweite Erfassungseinrichtung ist zur Erfassung eines in die Vorübergabeposition bewegten ersten Rahmenkonstruktionsabschnitts und zur Erzeugung einer einen in die Vorübergabeposition bewegten ersten Rahmenkonstruktionsabschnitt beschreibenden Vorübergabepositionsinformation eingerichtet. Die zweite Erfassungseinrichtung kann wenigstens ein, z. B. akustisches, elektrisches, optisches oder haptisches, Erfassungselement umfassen, welches auf Grundlage, z. B. akustischer, elektrischer, optischer oder haptischer, Signale Rückschlüsse auf die Positionierung eines ersten Rahmenkonstruktionsabschnitts in der Vorübergabeposition ziehen kann. Konkrete Beispiele für ein Erfassungselement sind wiederum eine (akustische oder optische) Schranke oder ein (elektrischer und/oder mechanischer) Kontakt. Jeweilige Erfassungselemente können wiederum arbeitsstationseitig und/oder transportwagenseitig angeordnet oder ausgebildet sein. Unabhängig von ihrer konkreten Ausführungsform lässt sich über die zweite Erfassungseinrichtung erfassen, ob ein erster Rahmenkonstruktionsabschnitt in die Vorübergabeposition bewegt ist. Das jeweilige Erfassungsergebnis wird über die Vorübergabepositionsinformation abgebildet.

Es wurde erwähnt, dass der Transportwagen, insbesondere ausgehend von der Vorandockposition, auch in eine Andockposition bewegbar ist. Bei der Vorandock- und der Andockposition handelt es sich typischerweise um bestimmte horizontale (laterale) Positionen des Transportwagens relativ zu einer arbeitsstationseitigen Gehäusekonstruktion. In der Andockposition ist der Transportwagen mit einem im Vergleich zu der Vorandockposition geringeren Abstand beabstandet von einer jeweiligen arbeitsstationseitigen Gehäusekonstruktion oder unmittelbar anliegend an einer jeweiligen arbeitsstationseitigen Gehäusekonstruktion angeordnet. Der Transportwagen ist in der Andockposition derart an die arbeitsstationseitige Gehäusekonstruktion angedockt, dass eine Übergabe eines Pulvermoduls von dem Transportwagen in die Arbeitsstation, oder umgekehrt, möglich ist. In der Andockposition ist damit eine Übergabe eines Pulvermoduls von einem Transportwagen in eine Arbeitsstation, oder umgekehrt, möglich bzw. vorgesehen.

Bewegungen des Transportwagens von der Vorandockposition in die Andockposition setzen selbstverständlich eine Aufhebung einer etwaigen vermittels der ersten Sicherungseinrichtung realisierten Sicherung des Transportwagens in der Vorandockposition voraus. Grundsätzlich kann eine Bewegung des Transportwagens in die Andockposition manuell oder (teil)automatisiert erfolgen. In letzterem Fall kann z. B. die erste Sicherungseinrichtung verwendet werden, den Transportwagen ausgehend von der Vorandockposition in die Andockposition zu bewegen. Dies kann dadurch realisiert sein, dass durch das Zusammenwirken und eine Bewegung der arbeitsstationseitigen Sicherungselemente und der transportwagenseitigen Gegensicherungselemente relativ zueinander eine den Transportwagen von der Vorandockposition in die Andockposition bewegende Kraft, typischerweise eine Zugkraft, erzeugt wird. Die Kraft kann konkret durch eine den Transportwagen in die Andockposition bewegende Bewegung des mit dem transportwagenseitige Gegensicherungselement zusammenwirkenden, d. h. insbesondere gekoppelten, arbeitsstationseitigen Sicherungselements realisiert sein.

Die transportwagenseitige Hubeinrichtung kann eingerichtet sein, den ersten Rahmenkonstruktionsabschnitt, insbesondere ausgehend von der Vorübergabeposition, in die Übergabeposition auf Grundlage einer Vorübergabepositionsinformation zu bewegen (abzusenken). Insbesondere kann die Hubeinrichtung eingerichtet sein, den ersten Rahmenkonstruktionsabschnitt dann, wenn der Transportwagen in die Andockposition bewegt ist, insbesondere ausgehend von der Vorübergabeposition, in eine Bewegung in Richtung der Übergabeposition zu versetzen. Derart kann wiederum insbesondere die Sicherheit der Anlage verbessert werden.

Die Anlage nach der Erfindung umfasst ferner eine zweite Sicherungseinrichtung. Die zweite Sicherungseinrichtung ist zur Sicherung eines in die Übergabeposition bewegten ersten Rahmenkonstruktionsabschnitts eines Transportwagens in der Übergabeposition eingerichtet. Die zweite Sicherungseinrichtung ist sonach zur Sicherung der Position eines in die Übergabeposition bewegten ersten Rahmenkonstruktionsabschnitts, insbesondere relativ zu der arbeitsstationseitigen Gehäusekonstruktion, eingerichtet.

Die zweite Sicherungseinrichtung kann wenigstens ein arbeitsstationseitiges erstes Sicherungselement und wenigstens ein korrespondierendes transportwagenseitiges Gegensicherungselement umfassen. Das arbeitsstationseitige, d. h. an der Arbeitsstation angeordnete oder ausgebildete, erste Sicherungselement ist eingerichtet, mit einem transportwagenseitigen, d. h. an dem Transportwagen angeordneten oder ausgebildeten, Gegensicherungselement derart zusammenzuwirken, dass die Position des in die Übergabeposition bewegten ersten Rahmenkonstruktionsabschnitts relativ zu der arbeitsstationseitigen Gehäusekonstruktion gesichert ist, mithin der erste Rahmenkonstruktionsabschnitt (ohne Betätigung der Hubeinrichtung) nicht aus der Übergabeposition bewegt werden kann.

Das arbeitsstationseitige Sicherungselement und das transportwagenseitige Gegensicherungselement können in der Übergabeposition formschlüssig zusammenwirken. Das arbeitsstationseitige Sicherungselement kann demnach als Formschlusselement, d. h. z. B. als, insbesondere kegel- oder konusartiger bzw. - förmiger, Vorsprung, ausgebildet sein oder einen solchen umfassen. Das transportwagenseitige Gegensicherungselement kann als korrespondierendes Gegenformschlusselement, d. h. z. B. als, insbesondere kegel- oder konusartige bzw. - förmige, Aufnahme bzw. Buchse, ausgebildet sein oder eine solche umfassen. Ein entsprechendes Formschlusselement, insbesondere in Form eines kegel- oder konusartigen bzw. -förmigen Vorsprungs, kann aufgrund seiner geometrisch-konstruktiven Gestalt eine Zentrierfunktion etwa im Sinne eines Zentrierbolzens ausüben. Durch das Zusammenwirken eines Formschluss- und eines Gegenformschlusselements kann sonach eine Zentrierung des ersten Rahmenkonstruktionsabschnitts bzw. des gesamten Transportwagens relativ zu einer arbeitsstationseitigen Gehäusekonstruktion und somit eine Sicherung der Position des ersten Rahmenkonstruktionsabschnitts bzw. des gesamten Transportwagens in wenigstens zwei, insbesondere drei, orthogonal zueinander ausgerichteten Raumrichtungen realisiert werden.

Es wurde mehrfach erwähnt, dass in der Übergabeposition eine Übergabe eines Pulvermoduls von dem Transportwagen in eine Arbeitsstation, oder umgekehrt, möglich ist. Die transportwagenseitige Rahmenkonstruktion kann hierfür wenigstens eine Übergabeschnittstelle, insbesondere in Form einer Öffnung, umfassen, welche eine Übergabe eines Pulvermoduls aus der Aufnahmeeinrichtung in eine Arbeitsstation oder eine Übergabe eines Pulvermoduls aus einer Arbeitsstation in eine transportwagenseitige Aufnahmeeinrichtung ermöglicht. In analoger Weise kann eine arbeitsstationsseitige Gehäusekonstruktion wenigstens eine Übergabeschnittstelle, insbesondere in Form einer Öffnung, umfassen, welche eine Übergabe eines Pulvermoduls aus einer Arbeitsstation in eine transportwagenseitige Aufnahmeeinrichtung oder eine Übergabe eines Pulvermoduls aus einer transportwagenseitigen Aufnahmeeinrichtung in eine Arbeitsstation ermöglicht. In der Übergabeposition eines ersten Rahmenkonstruktionsabschnitts eines jeweiligen Transportwagens fluchtet die transportwagenseitige Übergabeschnittstelle typischerweise mit einer arbeitsstationsseitigen Übergabeschnittstelle, sodass eine Übergabe eines Pulvermoduls von dem Transportwagen in die Arbeitsstation, oder umgekehrt, ermöglicht ist.

Um eine vereinfachte, weil standardisierte Übergabe von Pulvermodulen zwischen den der Anlage zugehörigen Transportwagen und den der Anlage zugehörigen Arbeitsstationen innerhalb der Anlage zu ermöglichen, können jeweilige arbeitsstationsseitige und jeweilige transportwagenseitige Übergabeschnittstellen für alle der Anlage zugehörigen Arbeitsstationen und Transportwagen geometrisch-konstruktiv gleich, d. h. standardisiert, ausgeführt sein.

Jeweilige transportwagenseitige und jeweilige arbeitsstationseitige Übergabeschnittstellen können über eine Verschlusseinrichtung verschließbar sein. Die Verschlusseinrichtung kann ein Verschlusselement umfassen, welches zwischen einer Offenstellung, in welcher die jeweilige Übergabeschnittstelle zur Übergabe eines Pulvermoduls freigegeben ist, und einer Schließstellung, in welcher die jeweilige Übergabeschnittstelle zur Übergabe eines Pulvermoduls nicht freigegeben ist, bewegbar gelagert sein. Ein Bewegen des Verschlusselements in die Offen- bzw. in die Schließstellung, oder umgekehrt, kann automatisiert, z. B. in Abhängigkeit der Erfassung der Übergabeposition, d. h. in Abhängigkeit der Erfassung eines in die Übergabeposition bewegten ersten Rahmenkonstruktionsabschnitts, erfolgen. Eine Erfassung der Übergabeposition bzw. die Erfassung eines in die Übergabeposition bewegten ersten Rahmenkonstruktionsabschnitts kann über die zweite Erfassungseinrichtung oder über eine dritte Erfassungseinrichtung erfolgen. Die dritte Erfassungseinrichtung kann analog der zweiten Erfassungseinrichtung eingerichtet sein, sodass auf die diesbezüglichen Ausführungen verwiesen wird.

Die transportwagenseitige Aufnahmeeinrichtung kann eine Lagerungseinrichtung umfassen, welche zur, insbesondere hängenden, Lagerung wenigstens eines Pulvermoduls in dem Aufnahmeraum eingerichtet ist. Die Lagerungseinrichtung kann eingerichtet sein, ein Pulvermodul, insbesondere zwischen einer vollständig in dem Aufnahmeraum bzw. der Rahmenkonstruktion aufgenommenen ersten Position (Pulvermodullagerposition) und einer teilweise aus dem Aufnahmeraum bzw. der Rahmenkonstruktion herausragenden zweiten Position (Pulvermodulübergabeposition), bewegbar relativ zu dem ersten Rahmenkonstruktionsabschnitt zu lagern. Hierfür kann die Lagerungseinrichtung mehrere Lagerelemente, welche eine bewegbare Lagerung eines in dem Aufnahmeraum aufgenommenen Pulvermoduls relativ zu dem ersten Rahmenkonstruktionsabschnitt ermöglichen, umfassen. Bei entsprechenden Lagerelementen kann es sich z. B. um Gleit- oder Rollenlagerelemente handeln, welche unter Ausbildung einer bewegbaren Lagerung mit einem Pulvermodul zusammenwirken, d. h. z. B. in hierfür pulvermodulseitig vorgesehene, z. B. durch pulvermodulseitig vorhandene Ausnehmungen gebildete, Wirkabschnitte eingreifen.

Eine entsprechende Lagerungseinrichtung kann eine Pulvermodulsicherungseinrichtung umfassen. Die Pulvermodulsicherungseinrichtung ist zur Sicherung der Position eines in dem Aufnahmeraum aufgenommenen Pulvermoduls eingerichtet. Die Pulvermodulsicherungseinrichtung kann wenigstens ein rahmenkonstruktionsseitiges Sicherungselement umfassen, welches eingerichtet ist, mit einem pulvermodulseitigen Gegensicherungselement derart zusammenzuwirken, dass die Positionierung des in dem Aufnahmeraum aufgenommenen Pulvermoduls gesichert ist. Ein entsprechendes Sicherungselement kann zwischen einer Sicherungsstellung, in welcher es derart relativ zu einem pulvermodulseitigen Gegensicherungselement bewegt ist, dass es mit diesem unter Ausbildung einer Sicherung der Position eines Pulvermoduls zusammenwirkt, und einer Nichtsicherungsstellung, in welcher es derart relativ zu einem pulvermodulseitigen Gegensicherungselement bewegt ist, dass es nicht mit diesem unter Ausbildung einer Sicherung der Position eines Pulvermoduls zusammenwirkt, bewegbar sein.

Das rahmenkonstruktionsseitige Sicherungselement kann mit einem jeweiligen pulvermodulseitigen Gegensicherungselement in der Transportposition des ersten Rahmenkonstruktionsabschnitts zusammenwirken. Die Transportposition entspricht damit einer Sicherungsposition, in welcher die Position eines Pulvermoduls gegenüber unerwünschten Positionsänderungen gesichert ist. Dies kann derart realisiert sein, dass das pulvermodulseitige Gegensicherungselement in der Transportposition derart relativ zu dem rahmenkonstruktionsseitigen Sicherungselement bewegt ist, dass diese unter Ausbildung einer Sicherung des in dem Aufnahmeraum aufgenommenen Pulvermoduls zusammenwirken.

Das rahmenkonstruktionsseitige Sicherungselement und das pulvermodulseitige Gegensicherungselement können formschlüssig zusammenwirken. Das Sicherungselement kann als Formschlusselement, d. h. z. B. als, insbesondere bolzenartiger bzw. -förmiger, Vorsprung, ausgebildet sein oder ein solches umfassen und das Gegensicherungselement kann als korrespondierendes Gegenformschlusselement, d. h. z. B. als, insbesondere buchsenartige bzw. -förmige, Aufnahme für den Vorsprung, ausgebildet sein oder eine solche umfassen.

In zu der transportwagenseitigen Aufnahmeeinrichtung analoger Weise können auch jeweilige Arbeitsstationen eine entsprechende Lagerungseinrichtung umfassen. Die Lagerungseinrichtung kann eingerichtet sein, ein Pulvermodul entlang einer sich durch die Arbeitsstation erstreckenden Transportbahn bewegbar relativ zu der Gehäusekonstruktion zu lagern, wofür die Lagerungseinrichtung Lagerelemente, welche eine bewegbare Lagerung eines in der Lagerungseinrichtung angeordneten Pulvermoduls relativ zu der arbeitsstationseitigen Gehäusekonstruktion ermöglichen, umfasst. Bei entsprechenden Lagerelementen kann es sich wiederum z. B. um Gleit- oder Rollenlagerelemente handeln, welche unter Ausbildung einer bewegbaren Lagerung mit einem Pulvermodul zusammenwirken, d. h. z. B. in hierfür pulvermodulseitig vorgesehene, z. B. durch pulvermodulseitig vorhandene Ausnehmungen gebildete, Wirkabschnitte eingreifen.

Jeweilige transportwagenseitige und jeweilige arbeitsstationseitige Lagerungseinrichtungen fluchten in der Übergabeposition eines ersten Rahmenkonstruktionsabschnitts eines jeweiligen Transportwagens zweckmäßig miteinander, sodass sich eine sich zwischen Transportwagen und Arbeitsstation erstreckende durchgehende Transportbahn ergibt, welche es ermöglicht, dass in jeweiligen Lagerungseinrichtungen gelagerte Pulvermodule problemlos von einem Transportwagen in eine Arbeitsstation, und umgekehrt, übergebbar sind. Mit dem gleichen Zweck sind jeweilige transportwagenseitige Lagerungseinrichtungen und jeweilige arbeitsstationseitige Lagerungseinrichtungen zweckmäßig gleich bzw. standardisiert ausgebildet.

Die Erfindung betrifft neben der Anlage auch einen Transportwagen für eine entsprechende Anlage. Der Transportwagen zeichnet sich dadurch aus, dass er eine Rahmenkonstruktion umfasst, welche eine Aufnahmeeinrichtung umfasst, welche einen zur Aufnahme eines Pulvermoduls innerhalb der Rahmenkonstruktion eingerichteten Aufnahmeraum umfasst, wobei die Rahmenkonstruktion wenigstens zwei Rahmenkonstruktionsabschnitte umfasst, wobei ein erster Rahmenkonstruktionsabschnitt bewegbar relativ zu einem zweiten Rahmenkonstruktionsabschnitt, insbesondere in einer vertikal ausgerichteten Bewegungsrichtung, gelagert ist, wobei der Transportwagen wenigstens eine, insbesondere motorische, Hubeinrichtung umfasst, welche zur Erzeugung einer den ersten Rahmenkonstruktionsabschnitt in eine Bewegung relativ zu dem zweiten Rahmenkonstruktionsabschnitt versetzenden Hubkraft eingerichtet ist. Sämtliche Ausführungen im Zusammenhang mit der Anlage gelten analog für den Transportwagen.

Die Erfindung ist anhand von Ausführungsbeispielen in den Zeichnungsfiguren näher erläutert. Dabei zeigen:

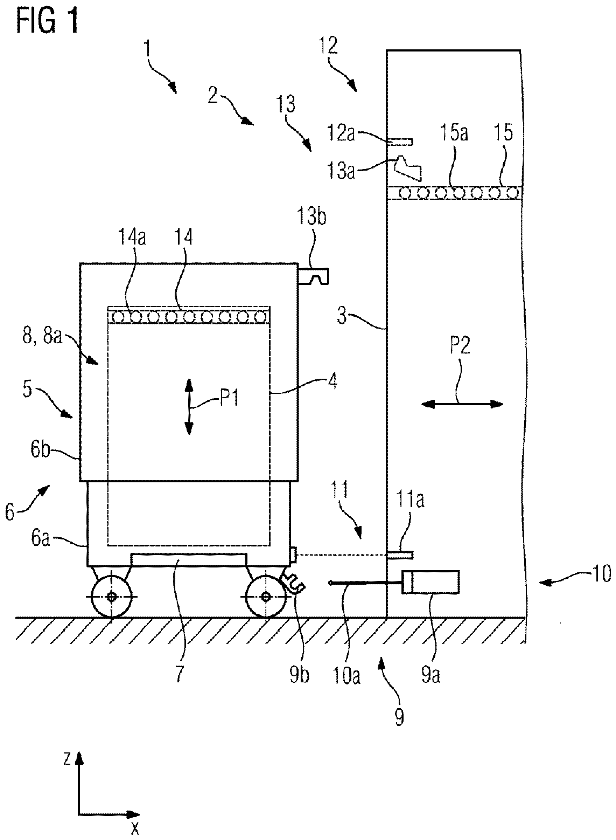

- Fig. 1 - 3: je eine Prinzipdarstellung eines Ausschnitts einer Anlage zur additiven Herstellung dreidimensionaler Objekte gemäß einem Ausführungsbeispiel.

Die Fig. 1 - 3 zeigen je eine Prinzipdarstellung eines Ausschnitts einer Anlage 1 zur additiven Herstellung dreidimensionaler Objekte gemäß einem Ausführungsbeispiel.

Die Anlage 1 umfasst, wenngleich in den Fig. jeweils nur eine einzige Arbeitsstation 2 gezeigt ist, typischerweise mehrere Arbeitsstationen 2, d. h. z. B. zur Durchführung additiver Arbeitsvorgänge eingerichtete Prozesstationen, welche als Vorrichtung (nicht näher bezeichnet) zur additiven Herstellung dreidimensionaler Objekte ausgebildet sind oder eine solche umfassen. Eine entsprechende Vorrichtung umfasst die zur Durchführung additiver Bauvorgänge erforderlichen Funktionskomponenten. Hierzu zählen insbesondere eine Beschichtungseinrichtung (nicht gezeigt), welche zur Ausbildung selektiv zu verfestigender Baumaterialschichten eingerichtet ist, und eine Belichtungseinrichtung (nicht gezeigt), welche zur selektiven Belichtung selektiv zu verfestigender Baumaterialschichten eingerichtet ist.

Andere Arbeitsstationen 2 können zur Durchführung nachbereitender Arbeitsvorgänge eingerichtete, auch als Nachbearbeitungsstation zu bezeichnende Arbeitsstationen 2 oder zur Durchführung vorbereitender Arbeitsvorgänge eingerichtete, auch als Vorbereitungsstationen zu bezeichnende Arbeitsstationen 2 sein.

Unabhängig von ihrer konkreten funktionellen Ausführung umfassen jeweilige Arbeitsstationen 2 eine eigene Gehäusekonstruktion 3, an oder in welcher die Funktionskomponenten der jeweiligen Arbeitsstation 2 angeordnet oder ausgebildet sind. Die Arbeitsstationen 2 sind als gesonderte, durch jeweilige Gehäusekonstruktionen 3 räumlich-körperlich definierte Funktionseinheiten der Anlage 1 zu sehen, welche in diversen Konfigurationen relativ zueinander, z. B. in einem oder mehreren Gebäude(abschnitte)n, insbesondere Fabrikhallen, positionierbar sind.

Die Anlage 1 umfasst eine Mehrzahl an im Rahmen der additiven Herstellung dreidimensionaler Objekte verwendeter Pulvermodule 4. Ein jeweiliges Pulvermodul 4 ist zur Aufnahme und/oder Abgabe von Baumaterial eingerichtet und umfasst hierfür typischerweise eine Pulverkammer (nicht gezeigt). Die Pulverkammer begrenzt einen mit Baumaterial befüllbaren Pulverraum. Der Pulverraum ist zumindest seitlich durch Wandungen (Pulverkammerwandungen) der Pulverkammer begrenzt. Bodenseitig kann der Pulverraum durch eine Trägereinrichtung (nicht gezeigt) begrenzt sein. Die Trägereinrichtung kann zwischen zwei Endstellungen, d. h. zwischen einer (bezogen auf die Höhe des Pulvermoduls 4) oberen und einer unteren Endstellung, relativ zu der Pulverkammer bewegbar gelagert sein. Die bewegbare Lagerung der Trägereinrichtung ermöglicht die Realisierung einer, insbesondere linearen, Bewegung der Trägereinrichtung entlang einer vertikalen Bewegungsachse bzw. in einer vertikalen Bewegungsrichtung. Die bewegbare Lagerung der Trägereinrichtung kann durch eine mit dieser gekoppelte, insbesondere (elektro)motorische, Antriebs- und/oder Aktoreinrichtung realisiert sein.

Konkret kann es sich bei einem Pulvermodul 4 um ein Baumodul, um ein Dosiermodul oder um ein Auffang- bzw. Überlaufmodul handeln.

Die Anlage 1 umfasst weiter eine Anzahl an Transportwagen 5. Ein jeweiliger Transportwagen 5 ist benutzerseitig, d. h. durch aktives Bewegen durch einen Benutzer, und/oder (teil)automatisiert über eine integrierte, insbesondere (elektro)motorische, Antriebseinrichtung (nicht gezeigt) zwischen den Arbeitsstation 2 der Anlage 1 bewegbar bzw. verfahrbar.

Der Transportwagen 5 umfasst eine Rahmenkonstruktion 6. Die Rahmenkonstruktion 6 umfasst zwei Rahmenkonstruktionsabschnitte 6a, 6b. Ein erster Rahmenkonstruktionsabschnitt 6a ist in einer durch den Doppelpfeil P1 angedeuteten vertikal ausgerichteten Bewegungsachse bzw. -richtung relativ zu einem zweiten Rahmenkonstruktionsabschnitt 6b bewegbar gelagert. Ersichtlich ist der erste Rahmenkonstruktionsabschnitt 6a oberhalb des zweiten Rahmenkonstruktionsabschnitts 6b angeordnet. Zur Realisierung von Bewegungen des ersten Rahmenkonstruktionsabschnitts 6a relativ zu dem zweiten Rahmenkonstruktionsabschnitt 6b umfasst der Transportwagen 5 eine, insbesondere (elektro)motorische, rein schematisch angedeutete Hubeinrichtung 7. Die Hubeinrichtung 7 ist zur Erzeugung einer den ersten Rahmenkonstruktionsabschnitt 6a in eine Bewegung, d. h. eine Hebe- oder Senkbewegung, relativ zu dem zweiten Rahmenkonstruktionsabschnitt 6b versetzenden Hubkraft eingerichtet.

Die Rahmenkonstruktion 6 umfasst eine in dem ersten Rahmenkonstruktionsabschnitt 6a angeordnete Aufnahmeeinrichtung 8. Die Aufnahmeeinrichtung 8 umfasst einen Aufnahmeraum 8a, welcher zur Aufnahme wenigstens eines Pulvermoduls 4 innerhalb der Rahmenkonstruktion 6 eingerichtet ist. Die Abmessungen des Aufnahmeraums 8a sind so gewählt, dass der Aufnahmeraum 8a zur (vollständigen) Aufnahme wenigstens eines Pulvermoduls 4 eingerichtet ist.

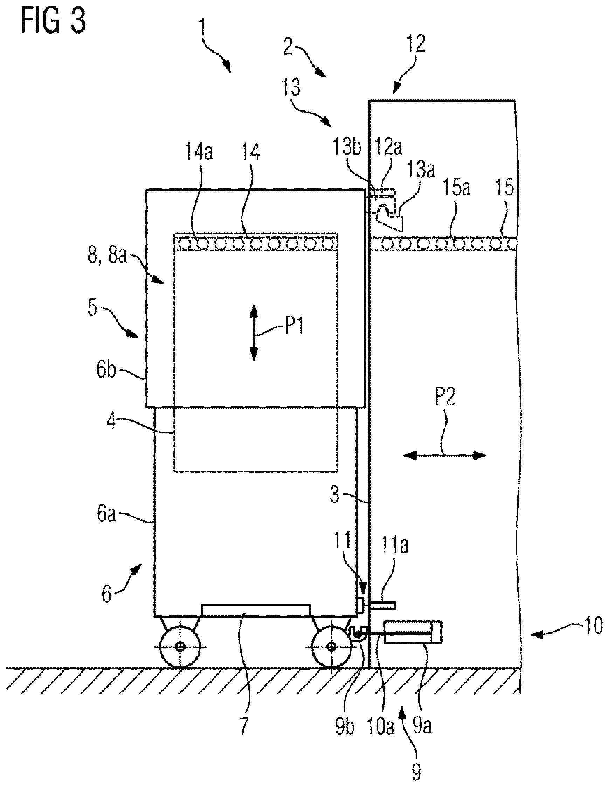

Die Hubeinrichtung 7 ist eingerichtet, den ersten Rahmenkonstruktionsabschnitt 6a wenigstens zwischen einer in Fig. 1 gezeigten Transportposition, in welcher eine Übergabe eines Pulvermoduls 4 von dem Transportwagen 5 in eine Arbeitsstation 2, oder umgekehrt, nicht möglich ist, und einer in Fig. 3 gezeigten Übergabeposition, in welcher eine Übergabe eines Pulvermoduls 4 von dem Transportwagen 5 in eine Arbeitsstation 2 möglich ist, zu bewegen. Die Übergabeposition stellt eine, insbesondere im Vergleich zu der Transportposition, obere Position des ersten Rahmenkonstruktionsabschnitts 6a dar. Die Transportposition stellt typischerweise eine, insbesondere im Vergleich zu der Übergabeposition, untere Position des ersten Rahmenkonstruktionsabschnitts 6a relativ zu dem zweiten Rahmenkonstruktionsabschnitt 6b dar. Mithin handelt es sich bei der Transport- bzw. der Übergabeposition um bestimmte vertikale Positionen des ersten Rahmenkonstruktionsabschnitts 6a.

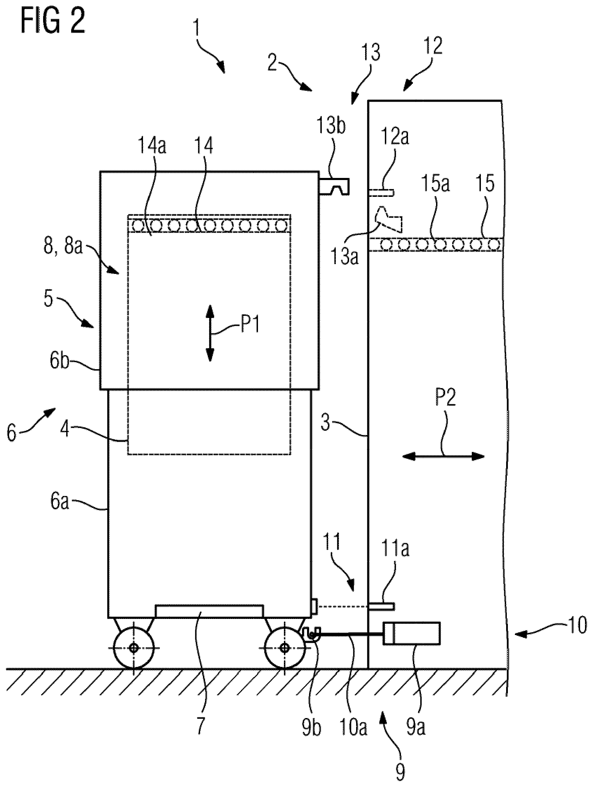

Der Transportwagen 5 ist in eine in Fig. 2 gezeigte Vorandockposition bewegbar. In der Vorandockposition ist der Transportwagen 5 mit einem bestimmten Abstand, d. h. insbesondere einem Abstand in einem Bereich zwischen 5 und 15 cm, beabstandet von der arbeitsstationsseitigen Gehäusekonstruktion 3 angeordnet. Die Vorandockposition kann als Vorstufe für eine Andockposition, in welcher der Transportwagen 5 an die arbeitsstationsseitige Gehäusekonstruktion 3 andockt, erachtet werden; in der Vorandockposition ist eine Übergabe eines Pulvermoduls 4 von dem Transportwagen 5 in die Arbeitsstation 2, oder umgekehrt, nicht möglich bzw. nicht vorgesehen.

Die Anlage 1 umfasst eine erste Sicherungseinrichtung 9, welche zur Sicherung des in die Vorandockposition bewegten Transportwagens 5 in der Vorandockposition eingerichtet ist. Die erste Sicherungseinrichtung 9 umfasst wenigstens ein arbeitsstationsseitiges erstes Sicherungselement 9a und wenigstens ein korrespondierendes transportwagenseitiges Gegensicherungselement 9b. Ein jeweiliges arbeitsstationsseitiges, d. h. an der Arbeitsstation 2 angeordnetes oder ausgebildetes, erstes Sicherungselement 9a ist eingerichtet, mit einem jeweiligen transportwagenseitigen, d. h. an dem Transportwagen 5 angeordneten oder ausgebildeten, Gegensicherungselement 9b derart zusammenzuwirken, dass die Position des in die Vorandockposition bewegten Transportwagens 5 relativ zu der arbeitsstationsseitigen Gehäusekonstruktion 3 gesichert ist. Das arbeitsstationsseitige Sicherungselement 9a und das transportwagenseitige Gegensicherungselement 9b wirken in der Sicherungsstellung formschlüssig zusammen. Das arbeitsstationsseitige Sicherungselement 9a ist als Formschlusselement, d. h. z. B. als, insbesondere hakenartiger bzw. -förmiger, Vorsprung, ausgebildet, das transportwagenseitige Gegensicherungselement 9b ist als korrespondierendes Gegenformschlusselement, d. h. z. B. als, insbesondere nutartige bzw. -förmige, Aufnahme für den Vorsprung, ausgebildet.

Anhand eines Vergleichs der Fig. 1 - 3 ist ersichtlich, dass das arbeitsstationseitige Sicherungselement 9a zwischen einer in Fig. 2 gezeigten Sicherungsstellung, in welcher es derart relativ zu dem transportwagenseitigen Gegensicherungselement 9b bewegt ist, dass es mit diesem unter Ausbildung einer Sicherung der Vorandockposition des Transportwagens 5 zusammenwirkt, und einer in Fig. 1 gezeigten Nichtsicherungsstellung, in welcher es derart relativ zu dem transportwagenseitigen Gegensicherungselement 9b bewegt ist, dass es nicht mit diesem unter Ausbildung einer Sicherung der Andockposition des Transportwagens 5 zusammenwirkt, bewegbar gelagert ist. Die bewegbare Lagerung des Sicherungselements 9a ist durch eine Stelleinrichtung 10 realisiert, welche ein mit dem Sicherungselement 9a (bewegungs)gekoppeltes Stellelement 10a umfasst. Die Stelleinrichtung 10 ist in den in den Fig. gezeigten Ausführungsbeispielen als eine einen bewegbar gelagerten Stellkolben umfassende Kolben-Zylinder-Einrichtung ausgebildet.

Auch das transportwagenseitige Gegensicherungselement 9b ist zwischen einer in Fig. 2 gezeigten Sicherungsstellung, in welcher es derart relativ zu dem arbeitsstationseitigen Sicherungselement 9a bewegt ist, dass es mit diesem unter Ausbildung einer Sicherung der Vorandockposition des Transportwagens 5 zusammenwirkt, und einer in Fig. 1 gezeigten Nichtsicherungsstellung, in welcher es derart relativ zu dem arbeitsstationseitigen Sicherungselement 9a bewegt ist, dass es nicht mit diesem unter Ausbildung einer Sicherung der Andockposition des Transportwagens 5 zusammenwirkt, bewegbar gelagert. Die bewegbare Lagerung des Gegensicherungselements 9b ist durch eine Stelleinrichtung (nicht nähre gezeigt) realisiert, welche ein mit dem Gegensicherungselement 9b (bewegungs)gekoppeltes Stellelement umfasst. Die Stelleinrichtung ist in den in den Fig. gezeigten Ausführungsbeispielen als Schwenkeinrichtung, welche zur Verschwenkung des Gegensicherungselements 9b zwischen der Sicherungs- und der Nichtsicherungsstellung eingerichtet ist, ausgebildet.

Die Anlage 1 umfasst eine erste Erfassungseinrichtung 11, welche zur Erfassung eines in die Vorandockposition bewegten Transportwagens 5 und zur Erzeugung einer einen in die Vorandockposition bewegten Transportwagen 5 beschreibenden Vorandockpositionsinformation und/oder zur Erfassung einer vermittels der ersten Sicherungseinrichtung 9 realisierten Sicherung eines in die Vorandockposition bewegten Transportwagens 5 und zur Erzeugung einer eine vermittels der ersten Sicherungseinrichtung 9 realisierte Sicherung eines in die Vorandockposition bewegten Transportwagens 5 beschreibenden ersten Sicherungsinformation eingerichtet ist. Die erste Erfassungseinrichtung 11 umfasst wenigstens ein, z. B. akustisches, elektrisches, optisches oder haptisches, Erfassungselement 11a, welches auf Grundlage, z. B. akustischer, elektrischer, optischer oder haptischer, Signale Rückschlüsse auf die Positionierung und/oder Sicherung eines Transportwagens 5 in der Vorandockposition ziehen kann. Konkret kann das Erfassungselement 11a z. B. als (akustische oder optische) Schranke oder als (elektrischer und/oder mechanischer) Kontakt ausgebildet. Entsprechende Erfassungselemente 11a können arbeitsstationseitig und/oder transportwagenseitig angeordnet oder ausgebildet sein.

Die transportwagenseitige Hubeinrichtung 7 ist eingerichtet, eine den ersten Rahmenkonstruktionsabschnitt 6a, insbesondere ausgehend von der Transportposition, in eine Bewegung relativ zu dem zweiten Rahmenkonstruktionsabschnitt 6b versetzende Hubkraft auf Grundlage einer Vorandockpositionsinformation und/oder auf Grundlage einer Sicherungsinformation zu erzeugen. Im Besonderen ist die Hubeinrichtung, insbesondere ausgehend von der Transportposition, eingerichtet, den ersten Rahmenkonstruktionsabschnitt 6a dann, wenn der Transportwagen 5 in die Vorandockposition bewegt ist und/oder wenn der in die Vorandockposition bewegte Transportwagen 5 in der Vorandockposition gesichert ist, in eine Bewegung in Richtung der Übergabeposition zu versetzen.

Der Transportwagen 5 kann eine der transportwagenseitigen Hubeinrichtung 7 zugeordnete Hubfreigabeeinrichtung (nicht gezeigt) umfassen. Die Hubfreigabeeinrichtung ist eingerichtet, auf Grundlage eines über eine, insbesondere transportwagenseitige, Benutzerschnittstelle (nicht gezeigt) benutzerseitig, z. B. durch eine haptische Eingabe, erzeugten Freigabebefehls eine Freigabeinformation zu erzeugen. Die Hubfreigabeeinrichtung kann entsprechend eine benutzerseitig betätigbare bzw. betätigende Betätigungsschnittstelle, d. h. z. B. einen Taster, Knopf, Touchscreen, etc. umfassen. Die Hubeinrichtung 7 kann eingerichtet sein, die den ersten Rahmenkonstruktionsabschnitt 6a relativ zu dem zweiten Rahmenkonstruktionsabschnitt 6b versetzende Hubkraft auf Grundlage einer seitens der Hubfreigabeeinrichtung erzeugten Freigabeinformation zu erzeugen. Mithin kann, bevor eine tatsächliche Bewegung des ersten Rahmenkonstruktionsabschnitts 6a erfolgt, eine Benutzerfreigabe erforderlich sein.

Die Hubeinrichtung 7 ist, wie sich aus Fig. 2 ergibt, ferner eingerichtet, den ersten Rahmenkonstruktionsabschnitt 6a, insbesondere ausgehend von der Transportposition des ersten Rahmenkonstruktionsabschnitts 6a und der Vorandockposition des Transportwagens 5, in eine in Fig. 2 gezeigte oberhalb der in Fig. 3 gezeigten Übergabeposition liegende Vorübergabeposition zu bewegen. Die Vorübergabeposition liegt (in vertikaler Richtung) einige cm, d. h. z. B. zwischen 5 und 15 cm, oberhalb der Übergabeposition. Die Vorübergabeposition kann als Vorstufe für die Übergabeposition, in welcher, wie erwähnt, eine Übergabe eines Pulvermoduls 4 von dem Transportwagen 5 in die Arbeitsstation 2, oder umgekehrt, möglich ist, erachtet werden; in der Vorübergabeposition ist eine Übergabe eines Pulvermoduls 4 von dem Transportwagen 5 in die Arbeitsstation 2, oder umgekehrt, typischerweise noch nicht möglich bzw. nicht vorgesehen.

Die Anlage 1 umfasst ferner eine zweite Erfassungseinrichtung 12, welche zur Erfassung eines in die Vorübergabeposition bewegten ersten Rahmenkonstruktionsabschnitts 6a und zur Erzeugung einer einen in die Vorübergabeposition bewegten ersten Rahmenkonstruktionsabschnitt 6a beschreibenden Vorübergabepositionsinformation eingerichtet ist. Die zweite Erfassungseinrichtung 12 umfasst wenigstens ein, z. B. akustisches, elektrisches, optisches oder haptisches, Erfassungselement 12a, welches auf Grundlage, z. B. akustischer, elektrischer, optischer oder haptischer, Signale Rückschlüsse auf die Positionierung des ersten Rahmenkonstruktionsabschnitts 6a in der Vorübergabeposition ziehen kann. Konkret kann das Erfassungselement 12a wiederum z. B. als (akustische oder optische) Schranke oder als (elektrischer und/oder mechanischer) Kontakt ausgebildet sein. Entsprechende Erfassungselemente 12a können wiederum arbeitsstationseitig und/oder transportwagenseitig angeordnet oder ausgebildet sein.

Anhand der Fig. ist ersichtlich, dass es sich bei der Vorandockposition (Fig. 2) und der Andockposition (Fig. 3) um bestimmte horizontale (laterale) Positionen des Transportwagens 5 relativ zu der arbeitsstationseitigen Gehäusekonstruktion3 handelt. Aus einem Vergleich der Fig. 2, 3 ergibt sich, dass der Transportwagen 5 in der Andockposition mit einem im Vergleich zu der Vorandockposition geringeren Abstand beabstandet von der arbeitsstationseitigen Gehäusekonstruktion 3 bzw. unmittelbar anliegend an der arbeitsstationseitigen Gehäusekonstruktion 3 angeordnet ist. Der Transportwagen 5 ist in der Andockposition derart an die arbeitsstationseitige Gehäusekonstruktion 3 angedockt, dass eine Übergabe eines Pulvermoduls 4 von dem Transportwagen 5 in die Arbeitsstation 2, oder umgekehrt, möglich ist.

Selbstverständlich setzen Bewegungen des Transportwagens 5 von der Vorandockposition in die Andockposition eine Aufhebung einer etwaigen vermittels der ersten Sicherungseinrichtung 9 realisierten Sicherung des Transportwagens 5 in der Vorandockposition voraus. Grundsätzlich kann eine Bewegung des Transportwagens 5 in die Andockposition manuell oder (teil)automatisiert erfolgen. In letzterem Fall kann z. B. die erste Sicherungseinrichtung 9 verwendet werden, den Transportwagen 5 ausgehend von der Vorandockposition in die Andockposition zu bewegen. Dies kann dadurch realisiert sein, dass durch das Zusammenwirken und eine Bewegung der arbeitsstationseitigen Sicherungselemente 9a und der transportwagenseitigen Gegensicherungselemente 9b relativ zueinander eine den Transportwagen 5 in die Andockposition bewegende Kraft, typischerweise eine Zugkraft, erzeugt wird. Die Kraft kann konkret durch eine den Transportwagen 5 in die Andockposition bewegende Bewegung des mit dem transportwagenseitige Gegensicherungselement 9b zusammenwirkenden, d. h. insbesondere gekoppelten, arbeitsstationseitigen Sicherungselements 9a realisiert sein.

Die transportwagenseitige Hubeinrichtung 7 ist eingerichtet, den ersten Rahmenkonstruktionsabschnitt 6a, insbesondere ausgehend von der Vorübergabeposition, in die Übergabeposition auf Grundlage einer Vorübergabepositionsinformation zu bewegen (abzusenken). Im Besonderen ist die Hubeinrichtung 7 eingerichtet, den ersten Rahmenkonstruktionsabschnitt 6a dann, wenn der Transportwagen 5 in die Andockposition bewegt ist, insbesondere ausgehend von der Vorübergabeposition, in eine Bewegung in Richtung der Übergabeposition zu versetzen.

Die Anlage 1 umfasst ferner eine zweite Sicherungseinrichtung 13, welche zur Sicherung des in die Übergabeposition bewegten ersten Rahmenkonstruktionsabschnitts 6a in der Übergabeposition eingerichtet ist. Die zweite Sicherungseinrichtung 13 umfasst wenigstens ein arbeitsstationseitiges erstes Sicherungselement 13a und wenigstens ein korrespondierendes transportwagenseitiges Gegensicherungselement 13b. Ein jeweiliges arbeitsstationseitiges, d. h. an der Arbeitsstation 2 angeordnetes oder ausgebildetes, erstes Sicherungselement 13a ist eingerichtet, mit einem jeweiligen transportwagenseitigen, d. h. an dem Transportwagen 5 angeordneten oder ausgebildeten, Gegensicherungselement 13b derart zusammenzuwirken, dass die Position des in die Übergabeposition bewegten ersten Rahmenkonstruktionsabschnitts 6a relativ zu der arbeitsstationseitigen Gehäusekonstruktion 3 gesichert ist, mithin der erste Rahmenkonstruktionsabschnitt 6a (ohne Betätigung der Hubeinrichtung 7) nicht aus der Übergabeposition bewegt werden kann.

Jeweilige arbeitsstationseitige Sicherungselemente 13a und jeweilige transportwagenseitige Gegensicherungselemente 13b wirken in der Übergabeposition formschlüssig zusammen. Jeweilige arbeitsstationseitige Sicherungselemente 13a sind als Formschlusselemente, d. h. als, insbesondere kegel- oder konusartige bzw. -förmige, Vorsprünge, ausgebildet. Jeweilige transportwagenseitige Gegensicherungselemente 13b sind als korrespondierende Gegenformschlusselemente, d. h. als, insbesondere kegel- oder konusartige bzw. -förmige, Aufnahmen bzw. Buchsen, ausgebildet. Ein entsprechendes Formschlusselement, insbesondere in Form eines kegel- oder konusartigen bzw. -förmigen Vorsprungs, übt aufgrund seiner geometrisch-konstruktiven Gestalt eine Zentrierfunktion etwa im Sinne eines Zentrierbolzens aus. Durch das Zusammenwirken jeweiliger Formschluss- und jeweiliger Gegenformschlusselemente ist sonach eine Zentrierung des ersten Rahmenkonstruktionsabschnitts 6a bzw. des gesamten Transportwagens 5 relativ zu der arbeitsstationseitigen Gehäusekonstruktion 3 und somit eine Sicherung der Position des ersten Rahmenkonstruktionsabschnitts 6a bzw. des gesamten Transportwagens in wenigstens zwei, insbesondere drei, orthogonal zueinander ausgerichteten Raumachsen bzw. -richtungen, vgl. das eingetragene Koordinatensystem, realisiert.

Es wurde mehrfach erwähnt, dass in der Übergabeposition eine Übergabe eines Pulvermoduls 4 von dem Transportwagen 5 in die Arbeitsstation 2, oder umgekehrt, möglich ist. Die transportwagenseitige Rahmenkonstruktion 6 umfasst hierfür wenigstens eine Übergabeschnittstelle (nicht gezeigt), insbesondere in Form einer Öffnung, welche eine Übergabe eines Pulvermoduls 4 aus der transportwagenseitigen Aufnahmeeinrichtung 8 in eine Arbeitsstation 2 oder eine Übergabe eines Pulvermoduls 4 aus der Arbeitsstation 2 in die transportwagenseitige Aufnahmeeinrichtung 8 ermöglicht. In analoger Weise umfasst die arbeitsstationsseitige Gehäusekonstruktion 3 wenigstens eine Übergabeschnittstelle (nicht gezeigt), insbesondere in Form einer Öffnung, welche eine Übergabe eines Pulvermoduls 4 aus der Arbeitsstation 2 in die transportwagenseitige Aufnahmeeinrichtung 8 oder eine Übergabe eines Pulvermoduls 4 aus der transportwagenseitigen Aufnahmeeinrichtung 8 in die Arbeitsstation 2 ermöglicht. Die die transportwagenseitige Übergabeschnittstelle fluchtet in der Übergabeposition mit der arbeitsstationsseitigen Übergabeschnittstelle, sodass eine Übergabe eines Pulvermoduls 4 von dem Transportwagen 5 in die Arbeitsstation 2, oder umgekehrt, ermöglicht ist.

Um eine vereinfachte, weil standardisierte Übergabe von Pulvermodulen 4 zwischen den der Anlage 1 zugehörigen Transportwagen 5 und den der Anlage 1 zugehörigen Arbeitsstationen 2 innerhalb der Anlage 1 zu ermöglichen, sind jeweilige arbeitsstationsseitige und jeweilige transportwagenseitige Übergabeschnittstellen für alle der Anlage 1 zugehörigen Arbeitsstationen 2 und Transportwagen 5 geometrisch-konstruktiv gleich, d. h. standardisiert, ausgeführt.

Jeweilige transportwagenseitige und jeweilige arbeitsstationseitige Übergabeschnittstellen können über eine Verschlusseinrichtung (nicht gezeigt) verschließbar sein. Eine entsprechende Verschlusseinrichtung kann ein Verschlusselement umfassen, welches zwischen einer Offenstellung, in welcher die jeweilige Übergabeschnittstelle zur Übergabe eines Pulvermoduls 4 freigegeben ist, und einer Schließstellung, in welcher die jeweilige Übergabeschnittstelle zur Übergabe eines Pulvermoduls 4 nicht freigegeben ist, bewegbar gelagert sein. Ein Bewegen des Verschlusselements in die Offen- bzw. in die Schließstellung, oder umgekehrt, kann automatisiert, z. B. in Abhängigkeit der Erfassung der Übergabeposition, d. h. in Abhängigkeit der Erfassung eines in die Übergabeposition bewegten ersten Rahmenkonstruktionsabschnitts 6a, erfolgen. Eine Erfassung der Übergabeposition bzw. die Erfassung eines in die Übergabeposition bewegten ersten Rahmenkonstruktionsabschnitts 6a kann über die zweite Erfassungseinrichtung 12 oder über eine dritte Erfassungseinrichtung (nicht gezeigt) erfolgen. Die dritte Erfassungseinrichtung kann analog der zweiten Erfassungseinrichtung 12 eingerichtet sein.

Anhand von Fig. 1 ist ersichtlich, dass die transportwagenseitige Aufnahmeeinrichtung 8 eine Lagerungseinrichtung 14 umfasst, welche zur, insbesondere hängenden, Lagerung wenigstens eines Pulvermoduls 4 in dem Aufnahmeraum 8a eingerichtet ist. Die Lagerungseinrichtung 14 ist eingerichtet, ein Pulvermodul 4, insbesondere zwischen einer vollständig in dem Aufnahmeraum 8a bzw. der Rahmenkonstruktion 6 aufgenommenen ersten Position (Pulvermodullagerposition) und einer teilweise aus dem Aufnahmeraum 8a bzw. der Rahmenkonstruktion 6 herausragenden zweiten Position (Pulvermodulübergabeposition), bewegbar zu lagern. Hierfür umfasst die Lagerungseinrichtung 14 mehrere Lagerelemente 14a, welche eine bewegbare Lagerung eines in dem Aufnahmeraum 8a aufgenommenen Pulvermoduls 4 ermöglichen. Bei den Lagerelementen 14a kann es sich z. B. um Gleit- oder Rollenlagerelemente handeln, welche unter Ausbildung einer bewegbaren Lagerung mit einem Pulvermodul 4 zusammenwirken, d. h. z. B. in hierfür pulvermodulseitig vorgesehene, z. B. durch pulvermodulseitig vorhandene Ausnehmungen gebildete, Wirkabschnitte (nicht gezeigt) eingreifen.

Eine entsprechende Lagerungseinrichtung 14 kann eine Pulvermodulsicherungseinrichtung (nicht gezeigt) umfassen. Die Pulvermodulsicherungseinrichtung ist zur Sicherung der Position eines in dem Aufnahmeraum 8a aufgenommenen Pulvermoduls 4 eingerichtet. Die Pulvermodulsicherungseinrichtung kann wenigstens ein rahmenkonstruktionsseitiges Sicherungselement umfassen, welches eingerichtet ist, mit einem pulvermodulseitigen Gegensicherungselement derart zusammenzuwirken, dass die Positionierung des in dem Aufnahmeraum 8a aufgenommenen Pulvermoduls 4 gesichert ist. Ein entsprechendes Sicherungselement kann zwischen einer Sicherungsstellung, in welcher es derart relativ zu einem pulvermodulseitigen Gegensicherungselement bewegt ist, dass es mit diesem unter Ausbildung einer Sicherung der Position eines Pulvermoduls 4 zusammenwirkt, und einer Nichtsicherungsstellung, in welcher es derart relativ zu einem pulvermodulseitigen Gegensicherungselement bewegt ist, dass es nicht mit diesem unter Ausbildung einer Sicherung der Position eines Pulvermoduls 4 zusammenwirkt, bewegbar sein.

Ein jeweiliges rahmenkonstruktionsseitige Sicherungselement kann mit einem jeweiligen pulvermodulseitigen Gegensicherungselement in der Transportposition des ersten Rahmenkonstruktionsabschnitts 6a zusammenwirken. Die Transportposition entspricht damit einer Sicherungsposition, in welcher die Position eines Pulvermoduls 4 gegenüber unerwünschten Positionsänderungen gesichert ist. Dies kann derart realisiert sein, dass das pulvermodulseitige Gegensicherungselement in der Transportposition derart relativ zu dem rahmenkonstruktionsseitigen Sicherungselement bewegt ist, dass diese unter Ausbildung einer Sicherung des in dem Aufnahmeraum 8a aufgenommenen Pulvermoduls 4 zusammenwirken.

Ein jeweiliges rahmenkonstruktionsseitiges Sicherungselement und ein jeweiliges pulvermodulseitiges Gegensicherungselement können formschlüssig zusammenwirken. Das Sicherungselement kann als Formschlusselement, d. h. z. B. als, insbesondere bolzenartiger bzw. -förmiger, Vorsprung, ausgebildet sein, und das Gegensicherungselement kann als korrespondierendes Gegenformschlusselement, d. h. z. B. als, insbesondere buchsenartige bzw. -förmige, Aufnahme für den Vorsprung, ausgebildet sein.

In zu der transportwagenseitigen Aufnahmeeinrichtung 8 analoger Weise kann auch die Arbeitsstation 2 eine entsprechende Lagerungseinrichtung 15 umfassen. Die Lagerungseinrichtung 15 ist eingerichtet sein, ein Pulvermodul 4 entlang einer durch den Doppelpfeil P2 angedeuteten, sich durch die Arbeitsstation 2 erstreckenden Transportbahn bewegbar relativ zu der Gehäusekonstruktion 3 zu lagern, wofür die Lagerungseinrichtung 15 Lagerelemente 15a, welche eine bewegbare Lagerung eines in der Lagerungseinrichtung 15 angeordneten Pulvermoduls 4 relativ zu der Gehäusekonstruktion 3 ermöglichen, umfasst. Bei entsprechenden Lagerelementen 15a kann es sich wiederum z. B. um Gleit- oder Rollenlagerelemente handeln, welche unter Ausbildung einer bewegbaren Lagerung mit einem Pulvermodul 4 zusammenwirken, d. h. z. B. in hierfür pulvermodulseitig vorgesehene, z. B. durch pulvermodulseitig vorhandene Ausnehmungen gebildete, Wirkabschnitte eingreifen.

Jeweilige transportwagenseitige und jeweilige arbeitsstationseitige Lagerungseinrichtungen 14, 15 fluchten in der Übergabeposition eines ersten Rahmenkonstruktionsabschnitts 6a miteinander, sodass sich eine sich zwischen Transportwagen 5 und Arbeitsstation 2 erstreckende durchgehende Transportbahn ergibt, welche es ermöglicht, dass in jeweiligen Lagerungseinrichtungen 14, 15 gelagerte Pulvermodule 4 problemlos von einem Transportwagen 5 in eine Arbeitsstation 2, und umgekehrt, übergebbar sind. Mit dem gleichen Zweck sind jeweilige transportwagenseitige Lagerungseinrichtungen 14 und jeweilige arbeitsstationseitige Lagerungseinrichtungen 15 gleich bzw. standardisiert ausgebildet.

## Patentansprüche

1. Anlage (1) zur additiven Herstellung dreidimensionaler Objekte, umfassend:
wenigstens einen, insbesondere benutzerseitig, bewegbaren, insbesondere verschiebbaren, Transportwagen (5);
wenigstens eine Arbeitsstation (2), welche zur Durchführung wenigstens eines Arbeitsvorgangs im Rahmen der additiven Herstellung dreidimensionaler Objekte eingerichtet ist, wobei die Arbeitsstation (2) unter Verwendung eines dieser vermittels des Transportwagens (5) zugeführten Pulvermoduls (4) zur Durchführung des wenigstens einen Arbeitsvorgangs eingerichtet ist, wobei die Arbeitsstation (2) umfasst: eine Gehäusekonstruktion (3),
eine erste Sicherungseinrichtung (9), welche zur Sicherung eines Transportwagens (5) an der Gehäusekonstruktion (3) eingerichtet ist, nachdem der Transportwagen (5) in eine Vorandockposition bewegt ist, wobei der Transportwagen (5) eine Rahmenkonstruktion (6) und eine Hubeinrichtung (7) umfasst, welche eingerichtet ist, wenigstens einen ersten Rahmenkonstruktionsabschnitt (6a) der Rahmenkonstruktion (6) anzuheben, wobei der erste Rahmenkonstruktionsabschnitt (6a) eine Aufnahmeeinrichtung (8) mit einem zur Aufnahme eines Pulvermoduls (4) eingerichteten Aufnahmeraum (8a) umfasst;
eine erste Erfassungseinrichtung (11), welche zur Erfassung des in die Vorandockposition bewegten und vermittels der ersten Sicherungseinrichtung (9) gesicherten Transportwagens (5) eingerichtet ist;
eine zweite Erfassungseinrichtung (12), welche zur Erfassung des vermittels der Hubeinrichtung (7) in eine Vorübergabeposition angehobenen ersten Rahmenkonstruktionsabschnitts (6a) und zur Erzeugung einer einen in die Vorübergabeposition bewegten ersten Rahmenkonstruktionsabschnitt (6a) beschreibenden Vorübergabepositionsinformation eingerichtet ist, wobei
die Hubeinrichtung (7) den ersten Rahmenkonstruktionsabschnitt (6a) anhebt, wenn die erste Erfassungseinrichtung (11) erfasst, dass der Transportwagen (5) in die Vorandockposition bewegt und/oder und vermittels der ersten Sicherungseinrichtung (9) gesichert ist; und
eine zweite Sicherungseinrichtung (13), welche zur Sicherung des Transportwagens (5) in einer Übergabeposition, wobei der erste Rahmenkonstruktionsabschnitt (6a) vermittels der Hubeinrichtung (7) angehoben ist, eingerichtet ist; wobei
der Transportwagen (5) von der Vorübergabeposition in die Übergabeposition bewegbar ist, wodurch der Transportwagen (5) über die zweite Sicherungseinrichtung (13) in der Übergabeposition gesichert werden kann, wobei das Pulvermodul (4) von dem in die Übergabeposition bewegten Transportwagen (5) in die Arbeitsstation (2) übergebbar ist.

2. Anlage nach Anspruch 1, wobei der wenigstens eine Arbeitsvorgang umfasst: die additive Herstellung dreidimensionaler Objekte, einen vor additiven Arbeits- bzw. Bauvorgängen durchzuführenden bzw. durchgeführten vorbereitenden Arbeitsvorgang und/oder einen nach additiven Arbeits- bzw. Bauvorgängen durchzuführenden bzw. durchgeführten nachbereitenden Arbeitsvorgang.

3. Anlage nach Anspruch 1 oder 2, wobei die Arbeitsstation (2) eine Gehäusekonstruktion (3) mit einer Lagerungseinrichtung (15) umfasst, welche eingerichtet ist, ein Pulvermodul (4) entlang einer sich durch die Arbeitsstation (2) erstreckenden Transportbahn bewegbar relativ zu der Gehäusekonstruktion (3) zu lagern.

4. Anlage nach einem der vorhergehenden Ansprüche, wobei die Arbeitsstation (2) eine Gehäusekonstruktion (3) mit einer Lagerungseinrichtung (15) umfasst, welche eingerichtet ist, ein Pulvermodul (4) entlang einer sich durch die Arbeitsstation (2) erstreckenden Transportbahn bewegbar relativ zu der Gehäusekonstruktion (3) zu lagern; und
der wenigstens eine Transportwagen (5) wenigstens eine Lagerungseinrichtung (14) umfasst, welche eine Transportbahn definiert, wobei
jeweilige transportwagenseitige und jeweilige arbeitsstationseitige Lagerungseinrichtungen (14, 15) in der Übergabeposition eines ersten Rahmenkonstruktionsabschnitts eines jeweiligen Transportwagens (5) miteinander fluchten, sodass sich eine sich zwischen Transportwagen (5) und Arbeitsstation (2) erstreckende durchgehende Transportbahn ergibt.

5. Anlage nach Anspruch 4, wobei die transportwagenseitige Lagerungseinrichtung (14) eingerichtet ist, ein Pulvermodul (4) beweglich von einer ersten Position, in welcher das Pulvermodul (4) in dem Aufnahmeraum (8a) aufgenommen ist, in eine zweite Position, in welcher das Pulvermodul (4) aus dem Aufnahmeraum (8a) und/oder dem ersten Rahmenkonstruktionsabschnitt (6a) ragt, zu lagern.

6. Anlage nach einem der Ansprüche 1 bis 5, wobei ein Sicherungselement der ersten Sicherungseinrichtung (9) zwischen einer Sicherungsstellung, in welcher es derart relativ zu einem transportwagenseitigen Gegensicherungselement bewegt ist, dass es mit diesem unter Ausbildung einer Sicherung der Vorandockposition des Transportwagens (5) zusammenwirkt, und einer Nichtsicherungsstellung, in welcher es derart relativ zu einem transportwagenseitigen Gegensicherungselement bewegt ist, dass es nicht mit diesem unter Ausbildung einer Sicherung der Andockposition des Transportwagens (5) zusammenwirkt, bewegbar gelagert ist, wobei die bewegbare Lagerung des Sicherungselements optional durch eine Stelleinrichtung realisiert ist, welche wenigstens ein mit dem Sicherungselement gekoppeltes Stellelement umfasst.

7. Anlage nach einem der Ansprüche 1 bis 6, wobei die erste Erfassungseinrichtung (11) ein akustisches Erfassungselement, ein elektrisches Erfassungselement, ein optisches Erfassungselement oder ein haptisches Erfassungselement umfasst; und/oder wobei die zweite Erfassungseinrichtung (12) ein akustisches Erfassungselement, ein elektrisches Erfassungselement, ein optisches Erfassungselement oder ein haptisches Erfassungselement umfasst.

8. Anlage nach einem der Ansprüche 1 bis 7, wobei die erste Sicherungseinrichtung (9) wenigstens ein arbeitsstationseitiges erstes Sicherungselement und wenigstens ein korrespondierendes transportwagenseitiges Gegensicherungselement umfasst, wobei das arbeitsstationseitige erste Sicherungselement eingerichtet ist, mit einem transportwagenseitigen Gegensicherungselement derart zusammenzuwirken, dass die Position des in die Vorandockposition bewegten Transportwagens relativ zu der arbeitsstationseitigen Gehäusekonstruktion gesichert ist, wobei optional das erste Sicherungselement (13a) und das zweite Sicherungselement (13b) jeweils Formschlusselemente ausgebildet sind oder umfassen.

9. Anlage nach einem der Ansprüche 1 bis 8, wobei die Vorandockposition beinhaltet, dass der Transportwagen (5) in einem Abstand von 5 cm bis 15 cm von der Gehäusestruktur (3) angeordnet ist.

10. Anlage nach einem der Ansprüche 1 bis 9, wobei die erste Erfassungseinrichtung (11) eingerichtet ist, eine einen in die Vorandockposition bewegten Transportwagen beschreibende Vorandockpositionsinformation zu erzeugen; und/oder wobei die erste Erfassungseinrichtung (11) eingerichtet ist, eine eine vermittels der ersten Sicherungseinrichtung realisierte Sicherung eines in die Vorandockposition bewegten Transportwagens beschreibende Sicherungsinformation zu erzeugen, wobei die Hubeinrichtung (7) vorzugsweise eingerichtet ist, wenigstens den ersten Rahmenkonstruktionsabschnitt (6a) auf Basis der Vorandockpositionsinformation und/oder auf Basis der Sicherungsinformation anzuheben.

11. Anlage nach einem der Ansprüche 1 bis 10, wobei die zweite Erfassungseinrichtung (12) eingerichtet ist, eine eine einen in die Vorübergabeposition bewegten ersten Rahmenkonstruktionsabschnitt beschreibende Vorübergabepositionsinformation zu erzeugen, und wobei die transportwagenseitige Hubeinrichtung eingerichtet ist, den ersten Rahmenkonstruktionsabschnitt, insbesondere ausgehend von der bzw. einer Vorübergabeposition, in die bzw. eine Übergabeposition auf Grundlage einer Vorübergabepositionsinformation zu bewegen.

12. Anlage nach einem der Ansprüche 1 bis 11, wobei die Andockposition beinhaltet, dass der Transportwagen (5) in einem Abstand von der Gehäusekonstruktion (3), welcher geringer als der der Vorandockposition entsprechende Abstand ist, angeordnet ist.

13. Anlage nach einem der Ansprüche 1 bis 12, wobei die Übergabeposition mit dem ersten Rahmenkonstruktionsabschnitt (6a), welcher in die Vorübergabeposition angehoben ist und dem Transportwagen (5), welcher in die Andockposition bewegt wurde, realisiert ist.

14. Verfahren zur Bereitstellung eines Pulvermoduls (4) zu einer Arbeitsstation (2) einer Anlage nach einem der vorhergehenden Ansprüche, wobei das Verfahren umfasst:
Sichern, vermittels einer ersten Sicherungseinrichtung (9), eines Transportwagens (5) an einer Gehäusekonstruktion (3), nachdem der Transportwagen (5) in eine Vorandockposition bewegt ist, wobei der Transportwagen (5) eine Rahmenkonstruktion (6) und eine Hubeinrichtung (7) umfasst, welche eingerichtet ist, wenigstens einen ersten Rahmenkonstruktionsabschnitt (6a) der Rahmenkonstruktion (6a) anzuheben, wobei der erste Rahmenkonstruktionsabschnitt (6a) eine Aufnahmeeinrichtung (8) mit einem zur Aufnahme eines Pulvermoduls eingerichteten Aufnahmeraum (8a) umfasst; Erfassen, vermittels einer ersten Erfassungseinrichtung (11), den in die Vorandockposition bewegten und vermittels der ersten Sicherungseinrichtung (9) gesicherten Transportwagens (5);
Erfassen, vermittels einer zweiten Erfassungseinrichtung (12), den in eine Vorübergabeposition angehobenen ersten Rahmenkonstruktionsabschnitts (6a) eingerichtet ist, wobei die Hubeinrichtung (7) den ersten Rahmenkonstruktionsabschnitt (6a) anhebt, wenn die erste Erfassungseinrichtung (11) erfasst, dass der Transportwagen (5) in die Vorandockposition bewegt und/oder und vermittels der ersten Sicherungseinrichtung (9) gesichert ist; und
Bewegen, vermittels der ersten Sicherungseinrichtung (9), die Rahmenstruktur (6) lateral von der Vorübergabeposition in eine Übergabeposition;
Sichern, vermittels einer zweiten Sicherungseinrichtung (13), des Transportwagens (5) in der Übergabeposition, wobei der erste Rahmenkonstruktionsabschnitt (6a) vermittels der Hubeinrichtung (7) angehoben ist, eingerichtet ist, wobei das Pulvermodul (4) von dem in die Übergabeposition bewegten Transportwagen (5) in die Arbeitsstation (2) übergebbar ist.

15. Verfahren nach Anspruch 14, umfassend: Übergeben des Pulvermoduls (4) entlang einer Transportbahn, welches sich zwischen dem Transportwagen (5) und der Gehäusekonstruktion (3) erstreckt, wobei die Gehäusekonstruktion (3) eine erste Lagerungseinrichtung (15) und der Transportwagen (5) eine zweite Lagerungseinrichtung (14) umfasst, wobei die erste Lagerungseinrichtung (15) und die zweite Lagerungseinrichtung (14) gemeinsam wenigstens einen Teil der Transportbahn definieren.

## Claims

1. System (1) for the additive manufacturing of three-dimensional objects, comprising:
at least one, in particular the user side, movable, in particular movable, transport trolleys (5);
at least one workstation (2), which is set up for carrying out at least one working operation in the context of additive production of three-dimensional objects, wherein the workstation (2) is set up using one of these powder module (4) supplied by means of the transport trolley (5) for carrying out at least one working operation, wherein the workstation (2) comprises:
a housing construction (3),
a first securing device (9) which is provided for securing a transport trolley (5) on the housing construction (3), after the transport trolley (5) is moved into a forward dock position, wherein the transport trolley (5) comprises a frame construction (6) and a lifting device (7), which is equipped to lift at least one first frame construction section (6a) of the frame construction (6), wherein the first frame construction section (6a) comprises a receiving device (8) with a receiving space set up for receiving a powder module (4);
a first detection device (11) which is set up to detect the transport wagon (5) secured to the pre-andock position and by means of the first safety device (9);
a second detection device (12), which is set up for the detection of the first frame construction section (6a) which is raised to a preload position (7) and for the generation of a first frame construction section (6a) that moves to the pre-delivery position, wherein the lifting device (7) lifts the first frame design section (6a) when the first detection device (11) detects that the transport trolley (5) is moved into the forward dock position and/or secured by means of the first safety device (9); and
a second safety device (13) which is set up for securing the transport trolley (5) in a transfer position, wherein the first frame construction section (6a) is raised by means of the lifting device (7); where
the transport trolley (5) can be moved from the pre-delivery position to the transfer position, whereby the transport trolley (5) can be secured via the second safety device (13) in the transfer position, wherein the powder module (4) can be transferred from the transport trolley (5) to the work station (2) moved to the transfer position.

2. System according to claim 1, wherein said at least one working operation comprises: the additive manufacturing of three-dimensional objects, a preparatory work operation to be carried out before additive work or construction operations and/or a follow-up process to be carried out after additive work or construction processes.

3. System according to claim 1 or 2, wherein the workstation (2) comprises a housing construction (3) with a storage device (15) which is arranged to store a powder module (4) along a transport path extending through the workstation (2) relative to the housing construction (3).

4. System according to one of the preceding claims, wherein the workstation (2) comprises a housing construction (3) with a storage device (15) which is arranged to store a powder module (4) along a transport path extending through the workstation (2) relative to the housing construction (3); and
which comprises at least one transport trolley (5) at least one storage device (14) which defines a transport path, wherein
each transport wagon side and respective workstation side storage devices (14, 15) in the transfer position of a first frame construction section of a respective transport trolley (5), so that a continuous transport railway extending between transport trolley (5) and work station (2) results.

5. System according to claim 4, wherein the transport trolley-side storage device (14) is provided to store a powder module (4) movably from a first position in which the powder module (4) is absorbed in the receiving room (8a) in a second position in which the powder module (4) protrudes from the receiving room (8a) and/or the first frame construction portion (6a).

6. System according to any one of claims 1 to 5, wherein a securing element of the first fuse device (9) between a fuse position in which it is moved so relative to a transport wagon-side counter-locking element that it interacts with it under forming a securing of the forward dock position of the transport trolley (5) and a non-lock position in which it is moved so relative to a transport wagon side counter-locking element, that it does not interact with this under forming a securing of the docking position of the transport trolley (5), is movably stored, wherein the movable storage of the securing element is optionally realised by a control device comprising at least one position element coupled to the securing element.

7. System according to any one of claims 1 to 6, wherein the first detection device (11) comprises an acoustic detection element, an electrical detection element, an optical detection element or a haptic detection element; and/or where:
the second detection device (12) comprises an acoustic detection element, an electrical detection element, an optical detection element or a haptic detection element.

8. System according to one of claims 1 to 7, wherein the first securing device (9) comprises at least one workstation side first fuse element and at least one corresponding transport wagon side counter-fuse element, wherein the workstation side first securing element is arranged, with a transport wagon side counter-locking element such that the position of the transport trolley moving to the forward dock position is secured relative to the workstation side housing construction, wherein optionally the first securing element (13a) and the second securing element (13b) are formed or comprise respectively.

9. System according to any one of claims 1 to 8, wherein the forward dock position includes that the transport trolley (5) is arranged at a distance of 5 cm to 15 cm from the housing structure (3).

10. System according to any one of claims 1 to 9, wherein the first detection device (11) is provided to generate a forward dock position information moving to the forward dock position; and/or wherein the first detection device (11) is provided, a fuse realised by means of the first fuse device of a transport trolley moving to the forward dock position descriptive securing information, wherein the lifting device (7) is preferably provided, at least the first frame construction section (6a) on the basis of the forward dock position information and/or on the basis of the securing information to be raised.

11. System according to one of claims 1 to 10, wherein the second detection means (12) is provided to generate a first frame design portion moving to the pre-transfer position portion, and wherein the transport carriage side lifting device is equipped to move the first frame design portion, in particular starting from the or a pre-transfer position position, to move to the or a transfer position on the basis of a pre-transfer position information.

12. System according to any one of claims 1 to 11, wherein the docking position includes that the transport trolley (5) is disposed at a distance from the housing construction (3), which is less than that corresponding to the forward dock position.

13. System according to any one of claims 1 to 12, wherein the transfer position with the first frame construction section (6a), which is raised to the pre-transfer position and the transport trolley (5), which has been moved into the docking position, is realised.

14. Method for providing a powder module (4) to a workstation (2) of an installation according to one of the preceding claims, wherein the method comprises:
securing, by means of a first securing device (9), a transport trolley (5) on a housing construction (3), after the transport trolley (5) is moved to a forward dock position, wherein the transport trolley (5) comprises a frame construction (6) and a lifting device (7), which is equipped to lift at least one first frame construction section (6a) of the frame construction (6a), wherein the first frame construction section (6a) comprises a receiving device (8) with a receiving space (8a) equipped to accommodate a powder module;
detecting, by means of a first detection device (11), which is moved to the pre-andock position and by means of the first safety device (9) secured carriage (5);
detecting, by means of a second detection device (12), which is set up in a pre-delivery position first frame construction portion (6a), wherein the lifting device (7) raises the first frame construction section (6a) when the first detection device (11) detects that the transport trolley (5) is moved into the forward dock position and/or secured by means of the first securing device (9); and
moving, by means of the first fuse device (9), the frame structure (6) laterally from the pre-delivery position to a transfer position;
securing, by means of a second safety device (13), of the transport trolley (5) in the transfer position, wherein the first frame construction section (6a) is raised by means of the lifting device (7), wherein the powder module (4) from the transport trolley moved to the transfer position (5) is transferred to the workstation (2).

15. Method according to claim 14, comprising: passing the powder module (4) along a transport path extending between the transport trolley (5) and the housing construction (3), wherein the housing construction (3) a first storage device (15) and the transport trolley (5) comprises a second storage device (14), wherein the first storage device (15) and the second storage device (14) jointly define at least part of the transport path.

## Revendications

1. Installation (1) pour la fabrication additive d'objets tridimensionnels, comprenant:
au moins un chariot de transport, en particulier de la part de l'utilisateur, mobile, en particulier coulissant, (5);
au moins un poste de travail (2) mis en place pour effectuer au moins une opération de travail dans le cadre de la fabrication additive d'objets tridimensionnels, le poste de travail (2) étant mis en place à l'aide d'un module de poudre (4) fourni par l'intermédiaire du chariot de transport (5) pour effectuer au moins une opération de travail, le poste de travail (2) comprenant:
une structure de boîtier (3),
un premier dispositif de sécurité (9) mis en place pour sécuriser un chariot de transport (5) sur la structure du boîtier (3) après que le chariot (5) est déplacé dans une position de préamarrage, le chariot de transport (5) comprenant une structure de châssis (6) et un dispositif de levage (7), conçu pour soulever au moins une première section (6a) de la structure du cadre (6), la première section de conception du cadre (6a) comprenant un dispositif d'accueil (8) avec un compartiment d'accueil (8a) aménagé pour accueillir un module de poudre (4);
un premier dispositif de détection (11) conçu pour enregistrer le véhicule de transport sécurisé (5), placé en position de préamarrage et à l'aide du premier dispositif de sécurité (9);
un deuxième dispositif de détection (12), qui est mis en place pour enregistrer le moyen du dispositif de levage (7) dans une position de prétransmission (6a) et pour produire une première section de conception de cadre (6a) descriptive de la position de prétransmission, dans laquelle:
le dispositif de levage (7) soulève la première section de conception du cadre (6a) lorsque le premier dispositif de détection (11) détecte que le chariot (5) est déplacé et/ou sécurisé par le biais du premier dispositif de sécurité (9); et
un deuxième dispositif de sécurité (13) installé pour sécuriser le chariot (5) dans une position de transfert, la première section de construction du cadre (6a) étant relevée par l'intermédiaire du dispositif de levage (7); où
le chariot (5) peut être déplacé de la position de prétransmission à la position de transfert, ce qui permet de sécuriser le chariot (5) par l'intermédiaire du deuxième dispositif de sécurité (13) dans la position de transfert, le module de poudre (4) pouvant être transféré du véhicule de transport (5) à la station de travail (2) déplacé vers la position de transfert (5).

2. Installation selon la revendication 1, dans lequel au moins une opération de travail comprend: la fabrication additive d'objets tridimensionnels, une opération préparatoire à effectuer ou à réaliser avant des opérations additives et/ou une opération de suivi à effectuer ou à effectuer après des opérations de travail ou de construction additives.

3. Installation selon la revendication 1 ou 2, dans laquelle le poste de travail (2) comprend une construction de boîtier (3) avec un dispositif de stockage (15) conçu pour stocker un module de poudre (4) le long d'une voie de transport s'étendant à travers le poste de travail (2) par rapport à la construction du boîtier (3).

4. Installation selon l'une des revendications précédentes, dans laquelle le poste de travail (2) comprend une construction de boîtier (3) avec un dispositif de stockage (15) conçu pour stocker un module de poudre (4) le long d'une voie de transport s'étendant à travers le poste de travail (2) par rapport à la structure du boîtier (3); et
qui comprend au moins un chariot de transport (5) au moins une installation de stockage (14) définissant une voie de transport,
les installations de stockage du côté des wagons de transport et de chaque poste de travail (14, 15) s'envolent dans la position de transfert d'une première partie de la construction du cadre d'un véhicule de transport respectif (5), de sorte qu'une voie de transport continue s'étendant entre le chariot (5) et le poste de travail (2).

5. Installation selon la revendication 4, dans laquelle l'installation de stockage côté chariot (14) est mise en place pour stocker un module de poudre (4) mobile à partir d'une première position dans laquelle le module de poudre (4) est inséré dans l'espace d'accueil (8a), dans une deuxième position dans laquelle le module en poudre (4) se trouve hors du local d'accueil (8a) et/ou de la première section de construction du cadre (6a).

6. Installation selon l'une des revendications 1 à 5, dans laquelle un élément de sécurité du premier dispositif de sécurité (9) entre une position de fusible dans laquelle il est déplacé par rapport à un élément de contre-fusible côté véhicule de transport qu'il interagit avec celui-ci en formant une protection de la position avant du chariot (5) et une position de non-sécurisation dans laquelle il est ainsi déplacé par rapport à un élément de contre-fusible côté véhicule de transport, qu'il n'intervient pas avec celui-ci sous la formation d'une sécurisation de la position d'amarrage du chariot de transport (5), étant donné que le stockage mobile de l'élément de sécurité est réalisé en option par une mise en place comprenant au moins un élément de poste couplé à l'élément de sécurité.

7. Installation selon l'une des revendications 1 à 6, dans lequel le premier dispositif de détection (11) comprend un élément de détection acoustique, un élément de détection électrique, un élément de détection optique ou un élément de détection haptique; et/ou le deuxième dispositif de détection (12) comprend un élément de détection acoustique, un élément de détection électrique, un élément de détection optique ou un élément de détection tactile.

8. Installation selon l'une des revendications 1 à 7, dans laquelle le premier dispositif de sécurité (9) comprend au moins un premier élément de sécurité côté poste de travail et au moins un élément de contre-sécurisation correspondant du véhicule de transport, dans lequel le premier élément de sécurité côté station de travail est mis en place pour fonctionner avec un élément de contre-sécurisation côté véhicule de manière à ce que la position du chariot de transport déplacé dans la position de prédémarrage soit assurée par rapport à la structure du boîtier côté poste de travail, le premier élément de sécurité (13a) et le deuxième élément de sécurité (13b) étant formés ou comprenant respectivement.

9. Installation selon l'une des revendications 1 à 8, dans laquelle la position avant-bord comprend que le chariot de transport (5) est disposé à une distance de 5 cm à 15 cm de la structure du boîtier (3).

10. Installation selon l'une des revendications 1 à 9, dans lequel le premier dispositif de détection (11) est mis en place pour produire une information de position prédémarrée descriptive dans la position de préamarrage; et/ou lorsque le premier dispositif de détection (11) est mis en place pour produire une information de sécurité descriptive réalisée à l'aide du premier dispositif de sécurité d'un chariot de transport déplacé vers la position de préamarrage, le dispositif de levage (7) étant de préférence mis en place pour soulever au moins la première section de construction du cadre (6a) sur la base des informations de position prédémarrage et/ou des informations de sécurité.

11. Installation selon l'une des revendications 1 à 10, dans lequel le deuxième dispositif de détection (12) est conçu pour produire une information de position de prétransmission descriptive d'une première section de construction de cadre déplacée dans la position de prétransmission, et dans laquelle le dispositif de levage côté chariot est mis en place pour déplacer la première section de construction du cadre, en particulier à partir de la position de prétransmission, vers laquelle ou une position de transfert sur la base d'une information de position de transfert.

12. Installation selon l'une des revendications 1 à 11, dans laquelle la position d'amarrage comprend que le chariot de transport (5) est placé à une distance de la construction du boîtier (3) inférieure à la distance correspondant à la position avant.

13. Installation selon l'une des revendications 1 à 12, dans laquelle la position de transfert est réalisée avec la première section de construction du cadre (6a), qui est soulevée dans la position de prétransmission et le chariot de transport (5) qui a été déplacé dans la position d'amarrage.

14. Procède de mise à disposition d'un module de poudre (4) à un poste de travail (2) d'une installation selon l'une des revendications précédentes, le procédé comprenant:
Fixation, par l'intermédiaire d'un premier dispositif de sécurité (9), d'un chariot de transport (5) sur une structure du boîtier (3), après que le chariot de transport (5) est déplacé dans une position de préamarrage, le chariot (5) comprenant une structure de châssis (6) et un dispositif de levage (7) conçu pour soulever au moins une première section (6a) de la structure du cadre (6a), la première section de conception du cadre (6a) comprenant un dispositif d'accueil (8) avec un compartiment d'accueil (8a) aménagé pour accueillir un module en poudre;
la saisie, à l'aide d'un premier dispositif de détection (11), le chariot de transport sécurisé à l'aide du premier dispositif de sécurité (9);
capter, au moyen d'un deuxième dispositif de détection (12) installé dans une première section de conception du cadre (6a) soulevée en position de prétransmission, le dispositif de levage (7) augmentant la première section de conception du cadre (6a) lorsque le premier dispositif de détection (11) détecte que le chariot (5) est déplacé et/ou sécurisé par le premier dispositif de sécurité (9); et
déplacer, au moyen du premier dispositif de sécurité (9), la structure du cadre (6) latéralement de la position de prétransmission à une position de transfert;
sécurisation, au moyen d'un deuxième dispositif de sécurité (13), du chariot de transport (5) en position de transfert, la première section de construction du cadre (6a) étant relevée par l'intermédiaire du dispositif de levage (7), le module de poudre (4) pouvant être transféré du chariot (5) à la station de travail (2) déplacé vers la position de transfert.

15. Procédé selon la revendication 14, complet: Transmission du module de poudre (4) le long d'une voie de transport s'étendant entre le chariot (5) et la construction du boîtier (3), la construction du boîtier (3) comprenant un premier dispositif de stockage (15) et le chariot (5) un deuxième dispositif de stockage (14), le premier dispositif de stockage (15) et le second (14) définissant conjointement au moins une partie de la voie de transport.
